# EUROPÄISCHE PATENTSCHRIFT

(11) **EP 2 748 579 B1**
(45) Veröffentlichungstag und Bekanntmachung des Hinweises auf die Patenterteilung: **06.01.2016**
(21) Anmeldenummer: 12753432.9
(22) Anmeldetag: 09.08.2012
(51) Int. Cl.: G01N 1/32, H01J 37/305, B23K 26/38

(54) **VERFAHREN ZUR PRÄPARATION EINER PROBE FÜR DIE MIKROSTRUKTURDIAGNOSTIK**
METHOD FOR THE PREPARATION OF A SAMPLE FOR MICROSTRUCTURE DIAGNOSTICS
PROCÉDÉ POUR PRÉPARER UN ÉCHANTILLON DESTINÉ AU DIAGNOSTIC MICRO-STRUCTURAL

(30) Priorität: 25.08.2011 DE 102011111190
(43) Veröffentlichungstag der Anmeldung: 02.07.2014
(73) Patentinhaber: Fraunhofer Gesellschaft zur Förderung der angewandten Forschung E.V., 80686 München (DE)
(72) Erfinder: HÖCHE, Thomas, 06120 Halle (DE)
(74) Vertreter: Pfenning, Meinig & Partner GbR
(86) Internationale Anmeldenummer: PCT/EP2012/065569
(87) Internationale Veröffentlichungsnummer: WO 2013/026707

(56) Entgegenhaltungen:
- EP-A2- 1 204 133
- EP-A2- 2 413 126
- DE-A1-102004 001 173
- DE-A1-102008 000 306
- US-A1- 2003 183 776
- US-A1- 2003 223 111
- US-A1- 2006 054 820
- US-A1- 2007 045 560
- US-A1- 2008 224 198
- US-A1- 2008 258 056
- US-A1- 2008 265 158
- US-A1- 2009 302 233
- US-A1- 2010 051 828
- US-A1- 2010 090 108
- US-B1- 6 194 720
- US-B1- 6 838 685
- US-B1- 7 112 790

## Beschreibung

Die vorliegende Erfindung bezieht sich auf ein Verfahren zum Präparieren einer Probe für ein mikrostrukturdiagnostisches Untersuchungsverfahren (Mikrodiagnostikverfahren), insbesondere einer z.B. lamellenförmigen Probe für die Transmissionselektronenmikroskopie (nachfolgend abgekürzt auch als TEM bezeichnet) oder auch einer Probe für die Rasterelektronenmikroskopie oder die Röntgenabsorptionsspektroskopie. Das erfindungsgemäße Verfahren eignet sich somit insbesondere für Mikrostrukturdiagnostikverfahren, bei denen durch das Abdünnen eines Präparats (zur endgültigen Probe) das methodeninhärente Anregungs- oder Signalvolumen reduziert und damit die Ortsauflösung gesteigert werden kann. Nachfolgend wird die vorliegende Erfindung nun anhand des Herstellens einer Probe für die Transmissionselektronenmikroskopie im Detail beschrieben. Das Verfahren kann jedoch in gleicher Weise auch zur Präparation einer Probe für andere Mikrostruktur-diagnostikverfahren eingesetzt werden.

Die Entwicklung aberrationskorrigierter Transmissionselektronenmikroskope wirft zunehmend die Frage nach einer schädigungsarmen und zeiteffizienten Gewinnung elektronentransparenter Präparate bzw. Proben auf. Entwicklungsbedarf besteht hier vorrangig für Verfahren, die schnell realisierbar und in der Lage sind, mikro- oder nanostrukturelle Details herauszupräparieren sowie einen hinreichend großen Ausschnitt der Mikrostruktur zu erschließen.

Aus dem Stand der Technik sind bereits unterschiedliche Verfahren zum Gewinnen von elektronentransparenten Proben bekannt. So ist für Metalle das Anspritzen mit einem Elektrolyten bekannt. Sprödbrüchige Materialien können zermahlen werden. Beim sogenannten "tripod grinding" erfolgt ein rein mechanisches Abdünnen eines Keils auf einer Keramik, einem Halbleiter oder einem Glas. Bei der Ultramikrotomie, einer Ultradünnschnitt-Technik, werden die Präparate in einem aufwendigen Verfahren in einen flüssigen Kunststoff eingebettet, der schließlich aushärtet. Mit Diamantmessern können von derart eingebetteten Proben Schnitte hergestellt werden. Die Ultramikrotomie wird dabei vorwiegend für weiches Material, aber auch für Glas und Keramik eingesetzt.

In jüngster Zeit wurden aberrationskorrigierte Transmissionselektronenmikroskope entwickelt, die eine Auflösung von einem Angström und darunter erlauben. Diese ermöglichen es, Probenareale in höchster Auflösung zu betrachten. Demgemäß steigen auch die Anforderungen, in Materialien elektronenstrahltransparente Probenareale (bzw. Proben) zielgenau in definierten Tiefen herauszupräparieren. Moderne, aberrationskorrigierte TEM erlauben auch bei relativ niedrigen Elektronenenergien von z.B. 60 oder 80 keV bereits ein Punktauflösungsvermögen im Angströmbereich (das Auflösungsvermögen nimmt mit zunehmender Wellenlänge, also abnehmender Energie der Elektronen ab). Dies hat den Vorteil, dass zunehmend auch bezüglich der auftreffenden Elektronenenergie sensitive Materialien ohne oder nur mit geringfügigen Zerstörungen mittels TEM untersucht werden können (je höher die Elektronenenergie liegt, desto stärker die insbesondere bei Materialien mit niedrigen Kernladungszahlen auftretenden Beschädigungen oder Zerstörungen). Um jedoch für Elektronen mit relativ niedriger Energie wie beispielsweise 60 oder 80 keV elektronenstrahltransparent zu sein, dürfen die zu untersuchenden Proben lediglich Dicken von einigen 10 bis wenigen 100 Nanometern aufweisen.

Das Herstellen solcher dünner Proben ist jedoch nach dem Stand der Technik äußerst aufwendig: So ist beispielsweise ein mindestens 4 bis 5 Stunden bis zu einem Tag benötigendes Vorgehen zum Herauspräparieren einer solchen Probendicke bekannt, bei dem zunächst ein z.B. 3 mm Durchmesser aufweisendes dünnes Scheibchen über mechanisches Planparallelschleifen herausgebildet wird, das beispielsweise eine Dicke von 100 µm aufweist, bevor dieses 100 µm dicke planparallele Scheibchen mittels eines Muldenschleifverfahrens ("Dimpeln") an seiner dünnsten Stelle auf etwa 20 bis 15 µm abgedünnt wird. Ein weiters Abdünnen durch Dimpeln ist in der Regel mechanisch nicht mehr stabil. Demgemäß ist ein weiterer Abdünnschritt erforderlich, der in der Regel durch z.B. edelgasbasiertes (z.B. mit Argon-Ionen) Ionenstrahlätzen mit flachem Einfallswinkel erfolgt (siehe z.B. A. Strecker, PRAKT. METALLOGR.-PR.M. 30: 482 ff., 1993).

Ein weiteres, aus dem Stand der Technik bekanntes Verfahren ist das Herstellen von Proben mit einem fokussierten Ionenstrahl in einer Ionenfeinstrahlanlage (FIB von englisch "focussed ion beam"). Dabei wird zunächst in einem Rasterelektronenmikroskop mit zusätzlicher Ionensäule zielgenau oberhalb eines herauszupräparierenden Probenabschnitts eine dünne, linienförmige Platinschutzschicht aufgebracht, bevor anschließend seitlich neben dieser Schutzschicht das Material mittels des Ionenstrahls weggeätzt wird. Mit dem FIB-Verfahren lassen sich dünne Proben mit einer Dicke im Bereich von 50 bis 100 nm sehr zielgenau herauspräparieren. Nachteilig ist jedoch, dass auch dieses Verfahren etwa einen halben Tag bis einen Tag zum Herauspräparieren der Probe in Anspruch nimmt, dass durch den Ionenstrahl auch im herauszupräparierenden (unter der Platinschutzschicht liegenden) Bereich eine gewisse Implantation in die Probenlamelle erfolgt (was zu einer Schädigung oder Verfälschung des eigentlich zu untersuchenden Materials führt), dass die maximale Größe der Lamelle im Bereich von etwa 20 µm x 5 µm liegt und dass die Probe lediglich nahe an der Oberfläche, nicht jedoch in der Tiefe eines Volumenmaterials herauspräpariert werden kann.

Ein Verfahren zur Herstellung von elektronentransparenten für Untersuchungen mittels Transmissionselektronenmikroskopie geeigneten Proben durch Ultrakurzpulslaserablation ist auch im DE 10 2004 001 173 A1 bekannt: es offenbart ein Verfahren zur Präparation einer Probe für die Mikrostrukturdiagnostik, insbesondere für die Transmissionselektronenmikroskopie TEM, die Rasterelektronenmikroskopie oder die Röntgenabsorptionsspektroskopie, wobei eine flache, planparallele Scheibe entlang ihrer beiden gegenüberliegenden Oberflächen jeweils so mit einem Laserstrahl bestrahlt wird, dass durch laserstrahlbedingten Materialabtrag in diese beiden Oberflächen jeweils eine verlaufende Vertiefung eingebracht wird. US 2006/0054820 A1, US 6194720 B1, US 7112790 B1 und US 2007/0045560 A1 offenbaren auch Vorgehensweisen zur Herstellung von Proben für die Mikrostukturdiagnostik.

Neuere Entwicklungen im Stand der Technik schließen das lasergeführte Spalten (DE 10 2008 052 006 A1) sowie den Einsatz des Laserbohrens bzw. des sogenannten (Laser)Wendelbohrschneidens zur Erzeugung von Langlöchern mit schrägen oder auch mit senkrechten Schnittkanten ein (DE 10 2008 000 306 A1) Ein weiteres Verfahren zum Herstellen einer TEM-Lamelle umfasst das Aufnehmen eines plattenförmigen Substrates mit einer Dicke in einer Halterung, das Herstellen einer ersten streifenförmigen Ausnehmung auf einer ersten Seite des Substrats unter einem ersten Winkel zu der Halterung mittels eines Ionenstrahls, und das Herstellen einer zweiten streifenförmigen Ausnehmung auf einer zweiten Seite des Substrats unter einem zweiten Winkel zu der Halterung mittels eines Ionenstrahls derart, dass die erste und die zweite streifenförmige Ausnehmung zueinander einen spitzen oder rechten Winkel bilden und zwischen sich einen Überlappungsbereich geringerer Dicke bilden (EP 2413126 A2).

Ausgehend vom Stand der Technik ist es die Aufgabe der vorliegenden Erfindung, ein Verfahren (sowie eine zum Durchführen dieses Verfahrens ausgebildete Vorrichtung) zur Verfügung zu stellen, mit dem TEM-Proben, insbesondere Lamellenproben, auf zuverlässige Art und Weise für eine Vielzahl unterschiedlichster zu untersuchender Materialien mit gegenüber dem Stand der Technik deutlich verringertem Zeitbedarf herauspräpariert werden können. Eine weitere Aufgabe ist das Erschließen großer Materialtiefen (einige 100 µm).

Diese Aufgabe wird durch ein Verfahren gemäß Anspruch 1 gelöst. Vorteilhafte Ausgestaltungsformen des Verfahrens lassen sich dabei jeweils den abhängigen Ansprüchen entnehmen.

Nachfolgend wird die vorliegende Erfindung zunächst allgemein, dann anhand von Ausführungsbeispielen beschrieben.

Die im Rahmen der Ausführungsbeispiele in Kombination miteinander verwirklichten einzelnen Merkmale müssen dabei im Rahmen der vorliegenden Erfindung nicht genau in den in den Ausführungsbeispielen gezeigten Kombinationen miteinander verwirklicht werden. Insbesondere können einzelne der gezeigten Bauelemente der Vorrichtung und/oder der beschriebenen Schritte des Verfahrens auch weggelassen werden (bzw. die Schritte ggf. auch in anderer Reihenfolge durchgeführt werden). Insbesondere können auch alle der in den Ausführungsbeispielen gezeigten einzelnen Merkmale bzw. Schritte der Erfindung jeweils für sich bereits eine Verbesserung gegenüber dem Stand der Technik darstellen und somit zur vorliegenden Erfindung beitragen.

Die vorliegende Erfindung nimmt sich den Gedanken des Wendelbohrschneidens (DE 10 2008 000 306 A1) zum Ausgangspunkt. Weiterführende Versuche in Bezug auf dieses Wendelbohrschneiden haben ergeben, dass durch die hohe mechanische Belastung (Rückstoßdruck bei der Laserablation) ein Herausbrechen des freistehenden, herausgearbeiteten (Proben-)Stegs erfolgt. Dabei kann die Bearbeitungsposition aufgrund der geringer werdenden mechanischen Stabilität bei möglichst dünnen herauszuarbeitenden Stegdicken auch nicht mehr mit Druckluft angeblasen werden, was die Bearbeitungsqualität weiter beeinträchtigt. Demgemäß ist das Wendelbohrschneiden nur sehr bedingt (oder gar nicht mehr) dazu geeignet, zuverlässig Lamellenproben mit Dicken kleiner 20 µm zu erzeugen.

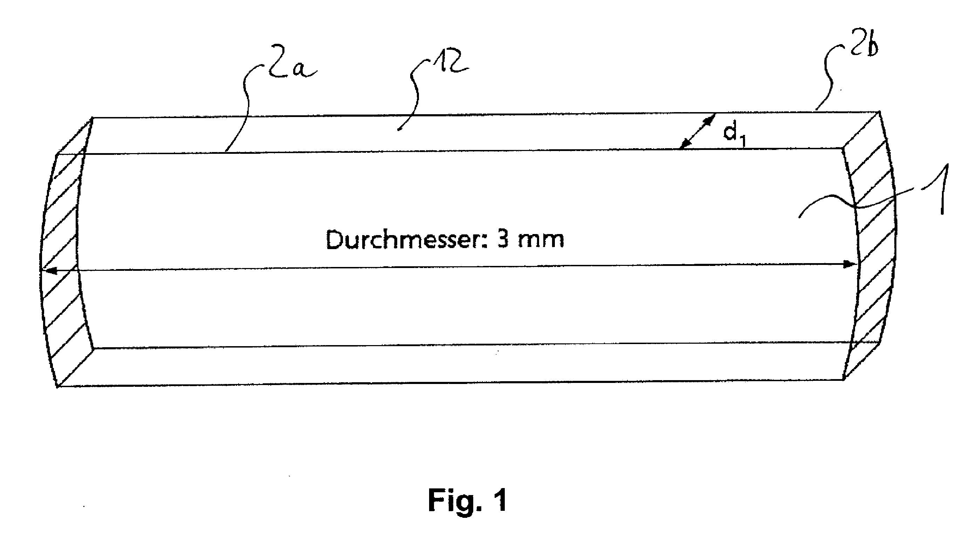

Die vorliegende Erfindung kann demgemäß die z.B. in der DE 10 2008 000 306 A1 beschriebene Grundtechnik des Wendelbohrens bzw. Wendelbohrschneidens (sowie ggf. auch die in Figur 1 dieser Offenbarung beschriebene Vorrichtung) zum erfindungsgemäßen Präparieren der Probe anwenden. Alternativ dazu kann z.B. erfindungsgemäß auch die in DE 10 2007 014 933 A1 beschriebene Trepaniertechnik eingesetzt werden.

Bei einem erfindungsgemäßen Verfahren zur Präparation einer TEM-Probe wird zunächst eine (z.B. mechanisch vorgedünnte oder per Wendelbohrschneiden erzeugte) flache, bevorzugt planparallele Scheibe beidseits entlang ihrer gegenüberliegenden Oberflächen jeweils so mit einem energiereichen Strahl (also z.B. einem Laserstrahl) bestrahlt, dass durch strahlbedingten Materialabtrag aus dieser Scheibe in die beiden gegenüberliegenden Oberflächen der dünnen Scheibe jeweils eine Vertiefung eingebracht wird. Diese beiden eingebrachten Vertiefungen verlaufen bevorzugt parallel zu einer zentralen Scheibenebene. In der Regel werden die beiden Vertiefungen nacheinander eingebracht, das heißt zunächst wird eine Vertiefung in eine Oberfläche der Scheibe strukturiert, bevor die Scheibe im Raum entsprechend translatiert und/oder rotiert wird (oder die Strahlquelle entsprechend bewegt wird), um auf der gegenüberliegenden Oberfläche die zweite Vertiefung einzustrukturieren.

Erfindungsgemäß werden die beiden Vertiefungen beidseits in die Oberflächen der Scheibe (also beidseits der zentralen Scheibenebene verlaufend) so eingebracht, dass sich ihre Längsachsen (bei Projektion dieser Längsachsen auf diese zentrale Scheibenebene gesehen) unter einem vordefinierten Winkel, der größer als 0° ist, schneiden und dass im Schnittbereich der beiden eingebrachten Vertiefungen zwischen diesen als Probe noch ein Materialabschnitt vordefinierter minimaler Dicke verbleibt. Vorzugsweise hat der vordefinierte Winkel einen Wert von größer gleich 10°, bevorzugt größer gleich 20°, bevorzugt größer gleich 30°. Die minimale Dicke wird dabei senkrecht zur zentralen Scheibenebene gemessen.

Bei dieser zentralen Scheibenebene handelt es sich in der Regel (zumindest bei einer planparallelen Scheibe) um diejenige Ebene, die parallel zu den beiden gegenüberliegenden Oberflächen der Scheibe und in der Mitte zwischen diesen verläuft. Dies muss jedoch nicht so sein, als zentrale Scheibenebene kann z.B. auch eine zwar zwischen den beiden Oberflächen, jedoch nicht genau in der Mitte zwischen diesen verlaufende Scheibenebene (oder auch eine zwar im Innern der Scheibe, jedoch gegenüber den beiden Oberflächen leicht verkippt verlaufende Oberfläche) verwendet werden.

Die minimale Dicke des noch verbleibenden, also nicht abgetragenen Materialabschnitts im Schnittbereich der beiden Vertiefungen kann dabei bereits eine minimale Dicke (von z.B. 0.5 bis einige wenige Mikrometer) aufweisen, die diesen Materialabschnitt bereits als Probe für ein TEM geeignet macht, da durch die vorbeschriebene beidseitige, gekreuzte Anordnung der Vertiefungen die Gesamtstruktur (insbesondere gegenüber einem lediglich einseitigen Einbringen nur einer Vertiefung in lediglich eine der beiden Oberflächen der Scheibe) substantiell an verwindungssteifigkeit gewinnt (siehe auch nachfolgend). Jedoch ist es auch möglich (dies wird in der Regel auch als zusätzlicher vorteilhafter Schritt des erfindungsgemäßen Verfahrens durchgeführt), dass der wie vorstehend beschrieben herausgearbeitete Materialabschnitt erst nach einem weiteren Abdünnschritt (zusätzlicher Ätzschritt, siehe nachfolgend) als elektronenstrahltransparente Probe verwendbar ist. Dies ist insbesondere dann der Fall, wenn die Probe mit Elektronen sehr niedriger Energie von z.B. 60 bis 80 keV, ggf. auch nur 20 keV, bestrahlt werden soll.

In einer ersten vorteilhaften Variante des erfindungsgemäßen Verfahrens kann somit der nach dem Einbringen der beiden Vertiefungen im Schnittbereich derselben und zwischen diesen verbliebene Materialabschnitt durch zusätzliches Ionenstrahlätzen ausgehend von der wie vorbeschrieben erzeugten Dicke (bzw. der realisierten minimalen Dicke des Materialabschnitts) in seiner Dicke weiter verringert werden. Es kann also ein weiteres Ausdünnen der vorbeschriebenen minimalen Dicke auf eine reduzierte minimale Dicke erfolgen.

Dieses Ionenstrahlätzen kann dabei unter in Bezug auf die Längsachsen der Vertiefungen gesehen streifendem Einfall in die Vertiefungen erfolgen. Es kann eine Breitstrahl-Ionenquelle eingesetzt werden. Ebenso ist es jedoch denkbar, mit einem fokussierten Ionenstrahl und/oder mit einer Ionenfeinstrahlanlage zu arbeiten, also diesen Schritt ganz analog wie bei der FIB durchzuführen. Auch ist es möglich, bei diesem zusätzlichen Ionenätzschritt zwei Ionenquellen (z.B. zwei Breitstrahl-Ionenquellen) einzusetzen, mit denen längs der eingebrachten Vertiefungen gesehen aus beiden Richtungen in diese Vertiefungen eingestrahlt werden kann. Ein solcher Ätzschritt mit einer oder auch zwei Breitstrahl-Ionenquellen kann beispielsweise wie in US 5,472,566 oder in "Precision Ion Polishing System (PIPS), Model 691", Gatan Inc., 5933 Coronado Lane, Pleasanton, CA 94588, USA, 2001, beschrieben erfolgen und ist dem Fachmann somit grundsätzlich bekannt.

(Unter einem streifenden Einfall wird dabei ein Einfall unter einem flachen Winkel von z.B. kleiner 10°, bevorzugt etwa 3° bis 5°, bezogen auf die zentrale Scheibenebene und entlang der Längsachsen verstanden.)

In einer weiteren vorteilhaften Ausführungsform der vorliegenden Erfindung wird der zum Einbringen der Vertiefungen verwendete, energiereiche Strahl (insbesondere in Form eines fokussierten Laserstrahls) beim Einbringen der Vertiefungen relativ zu seiner Einstrahlrichtung gesehen in eine Taumelbewegung versetzt (z.B. mittels einer Trepanieroptik oder auch mittels einer Wendelbohroptik; grundsätzlich können aber alle Strahlführungsoptiken eingesetzt werden, mit denen zylindrische oder langlochförmige Vertiefungen präzise einstrukturiert werden können). Hierdurch kann gewährleistet werden, dass die Vertiefungen entlang ihrer Längsachsen gesehen mit konstantem Querschnitt (der bevorzugt die Form eines Kreisabschnitts oder eines Langlochausschnitts annimmt) eingebracht werden können. Dabei ist es zusätzlich zur Taumelbewegung möglich (jedoch nicht notwendig), den energiereichen Strahl auch in eine Rotation um sich selbst zu versetzen. Eine solche Vorgehensweise des Führens eines fokussierten Laserstrahls (und eine dazu verwendete Vorrichtung, wie sie dann auch im Rahmen der vorliegenden Erfindung eingesetzt werden kann) ist dem Fachmann, wie bereits erwähnt, aus z.B. der DE 10 2008 000 306 A1 bekannt.

Alternativ dazu oder vorzugsweise in Kombination damit ist es jedoch auch möglich, die zu bearbeitende Scheibe während des Einbringens der Vertiefungen zu bewegen: Sie kann in eine Dreh- und/oder eine Schwingbewegung relativ zu einer Achse senkrecht zur Scheibenebene versetzt werden, wobei der maximale Bewegungswinkel vorteilhafterweise einige wenige Grad beträgt. Damit werden "curtaining"-Effekte, also unerwünschte Abschattungen, welche die Glattheit der Schnittfläche beeinträchtigen, reduziert.

Vorteilhafterweise wird die Scheibe zum Einbringen der Vertiefungen auf einer Drehachse, bei der es sich bevorzugt um eine euzentrische Drehachse handelt, positioniert. Dieses Positionieren (bzw. das Positionieren der Scheibe vor oder auch während des Einbringens der Vertiefungen ganz allgemein) kann mithilfe einer 5-Achs-Positioniereinrichtung erfolgen. Ein weiteres Ziel des Einsatzes einer solchen Positioniereinrichtung ist die Adressierung einer vordefinierten Tiefe durch gezielte Wahl von Eindringpositionen und Kreuzungswinkel. Dazu kann ein 3-Achsen-Verschiebetisch mit einer zusätzlichen Rotationsachse und einer zusätzlichen Linearachse verwendet werden. Solche 5-Achs-Positioniereinrichtungen sind dem Fachmann beispielsweise aus US 2003/0223111 A1 bekannt. Alternativ dazu kann aber auch eine 4-Achsen-Positioniereinrichtung wie z.B. ein 4-Achsen-Goniometer mit drei Linearachsen und einer Rotationsachse eingesetzt werden: Hierzu muss die Position des Fokus des energiereichen Strahls (in Bezug auf den Eindringort des Strahls in die Scheibe) mittels einer geeigneten Annahme über die Scheibenposition und/oder die Scheibenhöhe oder mittels eines Laserabstandsmessverfahrens bestimmt werden.

In einer weiteren vorteilhaften Ausführungsform (die selbstverständlich in Verbindung mit jeder der bereits beschriebenen Ausführungsformen realisiert werden kann) werden beim Bestrahlen entlang der beiden Oberflächen der Scheibe in diese Oberflächen jeweils mehrere Vertiefungen eingebracht. Das Einbringen erfolgt dabei bevorzugt dergestalt, dass auf jeder der beiden Oberflächen diese Vertiefungen mit ihren Längsachsen jeweils parallel zueinander verlaufend eingebracht werden. Die Vertiefungen der einen Oberfläche und diejenigen der anderen Oberfläche schneiden sich dann mehrfach jeweils unter dem vorbeschriebenen vordefinierten Winkel, so dass mehrere Schnittbereiche wie vorbeschrieben mit verbleibenden, bevorzugt bereits elektronenstrahltransparenten Materialabschnitten vordefinierter minimaler Dicke entstehen. Die so entstandenen Materialabschnitte können selbstverständlich wie vorbeschrieben durch zusätzliches Ionenstrahlätzen weiter ausgedünnt werden. Vorteilhafterweise werden dabei die Vertiefungen mindestens einer der beiden Oberflächen der Scheibe in Richtung senkrecht zu der zentralen Scheibenebene gesehen unterschiedlich tief in die betreffende Oberfläche eingebracht, beispielsweise um zu ermöglichen, dass die verbliebene Restdicke besser abgeschätzt werden kann, also die Elektronenstrahltransparenz besser bewertet werden kann. Die Einbringtiefe kann dabei von Vertiefung zu Vertiefung linear zu- oder abnehmen. Auch nichtlineare Variationen der Tiefe sind möglich (z.B. eine Vertiefung mit einer anderen Einbringtiefe als mehrere andere Vertiefungen mit derselben Einbringtiefe).

Vorteilhafterweise werden die Vertiefungen so eingebracht, dass der oder die verbleibende(n) Materialabschnitt(e) in einem vordefinierten Abstand bzw. in vordefinierten Abständen von einer stirnseitigen Schmalfläche (also dem Rand) der Scheibe entstehen. Die Vertiefungen können unter einem Winkel größer 0°, bevorzugt größer gleich 10°, bevorzugt größer gleich 15° zur Normalen dieser stirnseitigen Schmalfläche der Scheibe eingebracht werden. Besonders bevorzugt ist es, dass die einzelnen Vertiefungen mit ihren Längsachsen parallel zu der zentralen Scheibenebene verlaufend eingebracht werden (dass also die Vertiefungen bei einer planparallelen Scheibe parallel zu den beiden Scheibenoberflächen verlaufen). Die Vertiefungen können dabei - wie nachfolgend noch im Detail gezeigt - in Form eines Zylinderausschnitts oder eines Langlochausschnitts ausgeformt werden.

Vorzugsweise werden die Vertiefungen so eingebracht, dass der/die in dem/den Schnittbereich(en) entstehende(n) Materialabschnitt(e) (eine) vordefinierte minimale Dicke(n) zwischen 0.3 µm und 10 µm, vorzugsweise zwischen 0.5 µm und 5 µm aufweist/aufweisen. Die maximale Querschnittsausdehnung der Vertiefungen (senkrecht zu ihren Längsachsen und in der Regel auch parallel zur zentralen Scheibenebene gesehen) kann zwischen 50 µm und 500 µm, bevorzugt zwischen 100 µm und 200 µm betragen. Die maximale Einbringtiefe der Vertiefungen senkrecht zu der zentralen Scheibenebene gesehen beträgt vorzugsweise zwischen 20 µm und 100 µm, besonders bevorzugt zwischen 40 µm und 50 µm.

Der energiereiche Strahl kann ein fokussierter Strahl sein. Dabei kann es sich insbesondere um einen Laserstrahl handeln, der z.B. mittels eines Faserlasers erzeugt wird. Erfindungsgemäß sind in der Regel Pikosekunden- oder Femtosekundenlaser einzusetzen, es ist jedoch auch der Einsatz eines Nanosekundenlasers denkbar. Alternativ zu dem Erzeugen der Vertiefungen mittels Lasers kann jedoch auch ein entsprechend fokussierter Ionenätzstrahl oder ein fokussierter Plasmastrahl einer Hochraten-Plasma-Ionenquelle (z.B. einer Hochraten-Plasma-FIB-Ionenquelle) eingesetzt werden.

Erfindungsgemäß werden zum Vermeiden von Wärmeeinflusszonen bevorzugt Ultrakurzpulslaser (mit Pulsdauern im Piko- oder Femtosekundenbereich) eingesetzt. Zwar ist der Einsatz von Lasern mit Nanosekundenpulsen grundsätzlich auch denkbar, diese haben jedoch den Nachteil, dass beim laserbasierten Einbringen der Vertiefungen in Vertiefungsrändern in der Regel erzeugte Schädigungen der Probenstruktur hinsichtlich der Schädigungstiefe gegenüber Piko- oder Femtosekundenlasern deutlich zunehmen.

Die zum erfindungsgemäßen Einbringen der Vertiefungen verwendete Scheibe kann aus den unterschiedlichsten Materialien bestehen (beispielsweise aus Halbleitermaterialien oder aus in der Natur vorkommende Materialien wie beispielsweise Stein) oder auch als Materialverbund vorliegen und eine mittlere Ausdehnung, einen mittleren Durchmesser oder eine mittlere Kantenlänge von zwischen 1 mm und 5 mm, bevorzugt von 3 mm aufweisen. Dabei sind selbstverständlich kreisförmige Scheiben ebenso denkbar wie rechteckige oder viereckige. Die mittlere Dicke der Scheibe beträgt vorzugsweise zwischen 50 und 200 µm, bevorzugt 100 µm. Vorzugsweise beträgt die vorbeschriebene mittlere Ausdehnung, der mittlere Durchmesser oder die mittlere Kantenlänge mindestens das fünfzehnfache, bevorzugt mindestens das fünfundzwanzigfache der mittleren Dicke der Scheibe. Diese Scheibe kann beispielsweise durch mechanisches Schleifen oder Sägen, durch Lasererosion oder auch durch Plasma-Funkenerosion hergestellt werden.

Wie nachfolgend noch im Detail beschrieben, weist eine erfindungsgemäße Vorrichtung, die zum Durchführen eines der vorstehend beschriebenen erfindungsgemäßen Verfahrens ausgebildet ist, eine Strahlerzeugungseinheit zum Erzeugen des energiereichen Strahl und eine Probenhalterung, mit dem die Scheibe im energiereichen Strahl zur Bearbeitung positioniert werden kann, auf. Die Strahlerzeugungseinheit umfasst vorzugweise einen Pikosekundenlaser oder einen Femtosekundenlaser, dessen Strahlengang ein Wendelbohrkopf zum Positionieren des Strahls nachgeordnet sein kann. Die Probenhalterung ist vorzugsweise als 5-Achs-Positioniereinrichtung ausgebildet oder umfasst eine solche. Vorzugsweise ist darüber hinaus mindestens eine Breitstrahl-Ionenquelle (definitionsgemäß hier eine Quelle mit einem Strahldurchmesser von größer gleich 100 µm) oder eine Ionenfeinstrahlanlage (definitionsgemäß hier eine Quelle mit einem Strahldurchmesser von wenigen nm bis einigen µm) als Ionenstrahlätzeinheit vorgesehen, um nach dem Bearbeiten der Scheibe mit dem energiereichen Strahl zum Einbringen der Vertiefungen die entstehende(n) Materialabschnitt(e) nachdünnen zu können. Die Ionenquelle(n) kann/können beispielsweise mit einer Beschleunigungsspannung zwischen 1.5 keV und 6 keV betrieben werden. Aber auch Werte < 1 keV (z.B. zwischen 50 und 800 eV) sind vorteilhaft.
Gegenüber den aus dem Stand der Technik bekannten Verfahren hat die erfindungsgemäße Mikrobearbeitungsstrategie zur Zielpräparation von TEM-Proben insbesondere die folgenden Vorteile:
- Die Zielpräparation der Probe kann mit einer Zielgenauigkeit von wenigen Mikrometern oder sogar darunter durchgeführt werden. Dies ist wesentlich besser, als mit bisher gebräuchlichen mechanischen Verfahren (reicht jedoch nicht an die Nanometerpräzision eines FIB-Schnittes heran). Wie bereits beschrieben, kann jedoch die beschriebene Strahlabdünnstrategie als Vorstufe für einen nachfolgenden FIB-Prozess genutzt werden. Durch die Strahlmikrobearbeitung insbesondere mit einem Laser ergibt sich der Vorteil eines hochratigen Materialabtrags (mehr als 10⁶ µm³/s), der mit fokussierten Ionenstrahlen nicht erreicht werden kann (bei der normalen FIB lassen sich lediglich wenige µm³/s erreichen, auch mit Hochraten-Plasma-FIB lassen sich lediglich 2 x 10³ µm³/s erreichen). Zudem werden durch die Möglichkeit der Wahl der Zielpräparationstiefe t (siehe nachfolgend) auch größere Materialtiefen zugänglich.
- Durch eine beim Einbringen von Langlöchern (siehe nachfolgend) mögliche Schnittführung einer nicht geraden Trajektorie (Einbringen der Vertiefungen mit unterschiedlicher Einbringtiefe) ist es ferner möglich, einen Indikatorbereich vorzusehen, anhand dessen die verbliebene Restdicke (z.B. durch optische Beobachtung) abgeschätzt und damit die Elektronentransparenz bewertet werden kann. Hierzu kann (beim Durchführen eines Ionenstrahlätzschrittes zum weiteren Verringern der Dicke der verbleibenden Materialabschnitte) auch beispielsweise das REM-Transparenzverfahren von R. Salzer et al. (Proceedings of Microscopy and Microanalysis, 2009, Cambridge University Press, NY, USA (2009) 340 bis 341) zuhilfe genommen werden.
- Beispielsweise gegenüber dem in der DE 10 2008 000 306 A1 Beschriebenen hat die vorliegende Erfindung den Vorteil, dass ein wesentlich dickerer Steg aus Volumenmaterial (ca. 100 µm Dicke) zur Stabilisierung der Probe beiträgt und nur sehr kleine Bereich (gebildet durch die sich unter einem Winkel schneidenden Scharten, also den verbleibenden Materialabschnitten in den Schnittbereichen entsprechend) sehr dünn sind. Diese Scharten bzw. Vertiefungen können mit geringer Laserleistung erzeugt werden, ohne das ein Nachteil bei der benötigten Bearbeitungszeit erwächst. Gleichzeitig wird die Schädigung (siehe auch nachfolgend) auf ein Minimum reduziert. Die auf diese Weise erzeugten Strukturen sind somit ideal als Vorstufe für einen sich ggf. anschließenden Ionenbreitstrahlätzschritt entlang der Vertiefungen geeignet, wobei durch die erzielbare geringe Restdicke der dünnen Schartenkreuzungsbereiche (also der Materialabschnitte mit ihrer minimalen Dicke) mit Ätzzeiten von einigen 10 Minuten (statt vieler Stunden) zu rechnen ist.
- Ein weiterer Vorteil ist darin zu sehen, dass etwa in Materialverbünden die oftmals interessierende Grenzfläche als Schnittbereich bzw. Schartenüberlappungsbereich genau hinsichtlich der Tiefe t adressiert werden kann und damit auch tief im Materialinneren verborgene Strukturen zugänglich werden (etwa bei Fragestellungen aus dem Bereich der Fügetechnik, wo somit durch die Erfindung aufwendige Rückdünnverfahren überflüssig werden).
- Das Verfahren kann somit auch die FIB-Technologie sinnvoll ergänzen, indem mittels FIB nicht zugängliche Bereiche eines Bulkmaterials (beispielsweise in großer Tiefe) mit einer Genauigkeit von wenigen Mikrometern zielpräpariert werden können. Außerdem können durch die Erzeugung mehrerer Schartenüberlagerungsbereiche bzw. Materialabschnitte deutlich aussagekräftigere Fügeanalysen vorgenommen werden.
- Die Erfindung hat somit den Vorteil, sämtliche langwierige, dem Ionenstrahlätzen vorgelagerte Prozesse (wie beispielsweise Diamantdrahtsägen, mechanisches Schleifen und Polieren, Ultraschallkernschneiden und Muldenschleifen) überflüssig zu machen. Das erfindungsgemäße Verfahren ist deutlich zielgenauer und signifikant zeitsparender (einige Minuten statt beispielsweise 4 bis 8 Stunden) als die zu ersetzenden Verfahren.
- Die Erfindung kann im Rahmen eines einen Pikosekundenlaser sowie einen Wendelbohrkopf umfassenden Tischgeräts verwirklicht werden, welches nur unwesentlich teurer, ggf. sogar preisgünstiger als die Summe der oben genannten zu ersetzenden Gerätschaften ist und keine hohen laufenden Kosten aufwirft (außer Wartungskosten). Ein solches erfindungsgemäßes Vorgehen benötigt kein Verbrauchsmaterial wie metallgebundene Diamantschleifscheiben oder Borcarbidpulver zum Ultraschallkernschneiden, wie Diamantdrähte zum Sägen oder wie Diamantsuspensionen zum Muldenschleifen.

Nachfolgend wird die vorliegende Erfindung anhand konkreter Ausführungsbeispiele beschrieben. Dabei zeigen:
- Figur 1: eine schematische Darstellung der planparallelen Ausgangsform für die Lasermikrobearbeitung (ca. 100 µm dicker Scheibenabschnitt von 3 mm Durchmesser).
- Figur 2: die geometrische Anordnung jeweils einer eingebrachten Vertiefung auf der Vorder- und auf der Rückseite der in Figur 1 gezeigten Scheibe, wobei im Überlappungsbereich (Schnittbereich) der beiden Vertiefungen ein 0,5 µm bis wenige Mikrometer dickes Areal (Materialabschnitt) entstanden ist.
- Figur 3: eine geometrische Anordnung entsprechend Figur 2, jedoch in diesem Falle mit nicht zylinderförmigen, sondern langlochförmigen Vertiefungen.
- Figur 4: eine Vorrichtung zum Durchführen des erfindungsgemäßen Verfahrens, mit der die in Figuren 1 bis 3 gezeigten Strukturierungen erzielt werden können.
- Figur 5: ein Querschnitt durch eine Schnittflanke, die mit einem Wendelbohrkopf in Kombination mit einem Pikosekundenlaser in einem Siliziumwafer erzeugt wurde.
- Figur 6: eine geometrische Anordnung mehrerer Vorder- und rückseitiger Scharten, in deren Überlappungsbereichen jeweils wenige Mikrometer dicke Materialabschnitte verbleiben.
- Figur 7: eine Anordnung mehrerer vorder- und rückseitiger Vertiefungen, deren Überlappungsbereiche bzw. Schnittbereiche durch unterschiedliche Bearbeitungstiefen (abhängig vom Winkel γ) unterschiedlich dick sind.

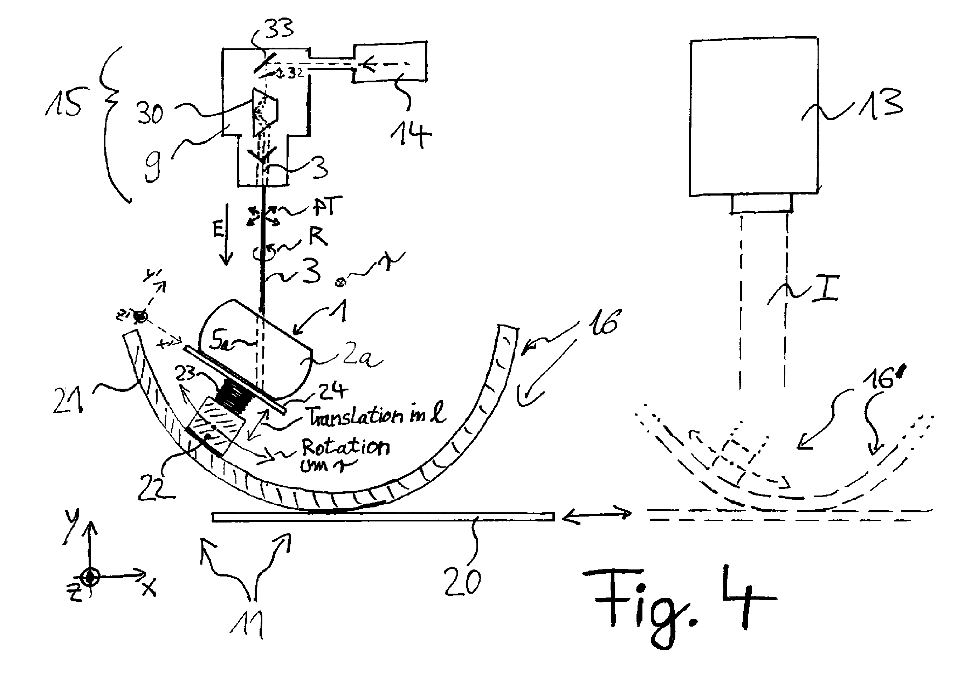

Figur 1 zeigt als Ausgangsbasis für ein erfindungsgemäßes Verfahren eine auf eine Dicke d₁ von 100 µm weitgehend planparallel abgedünnte Scheibe 1. Die Scheibe wurde durch mechanisches Schleifen, durch Lasererosion oder durch Plasma-Funkenerosion oder durch eine andere aus dem Stand der Technik bekannte Bearbeitungstechnik erzeugt und so konfektioniert, dass sie aufgrund ihres Durchmessers von 3 mm in einen Standard-TEM-Halter aufgenommen werden kann. Der Zuschnitt der Scheibe 1 auf den Durchmesser von 3 mm kann auch sehr einfach mit einem auch für das erfindungsgemäße Einbringen der Vertiefungen zu nutzenden Lasermikrobearbeitungssystem (vergleiche z.B. DE 10 2008 000 306 A1 oder auch Figur 4) erfolgen. Die dem Betrachter zugewandte Oberfläche der Scheibe ist hier mit 2a bezeichnet, ihre dem Betrachter abgewandte Rückseite mit dem Bezugszeichen 2b. In diese beiden Oberflächen werden, wie nachfolgend noch im Detail beschrieben, die Vertiefungen einstrukturiert. Zur besseren Darstellung ist die Scheibe 1 lediglich als Ausschnitt entlang des Durchmessers gezeigt, wobei die diesem Ausschnitt entsprechende, oben liegend gezeigte stirnseitige Schmalfläche der Scheibe 1 hier das Bezugszeichen 12 trägt. Die nachfolgende geometrische Beschreibung des erfindungsgemäßen Vorgehens erfolgt zur vereinfachten Darstellung so, wie wenn der gezeigte Ausschnitt aus der Scheibe 1 als reale Probe der Verarbeitung unterworfen werden würde (also die stirnseitige Schmalfläche 12 tatsächlich vorhanden wäre). Reale zu bearbeitende abgedünnte Scheiben, die vorzugsweise in Form einer vollständigen kreisförmigen Scheibe ausgebildet sind, können jedoch (bei entsprechender Wahl des Kreisrandes als stirnseitige Schmalfläche) entsprechend bearbeitet werden.

In Form dieser TEM-kompatiblen Ausgangsstruktur ist die Scheibe 1 für die weitere Bearbeitung, wie sie nachfolgen beschrieben wird, geeignet (und kann nach Abschluss des erfindungsgemäßen Verfahrens direkt ins TEM eingeschleust werden). Für kleinere Probenabmessungen und/oder nicht vollkreisförmige Scheiben (z.B. in Form des in Figur 1 gezeigten Ausschnitts) muss eine geeignet angepasste Probenaufnahme genutzt werden oder das Präparat muss in eine vollständig kreisförmige Scheibe von geeignetem Durchmesser eingebettet werden.

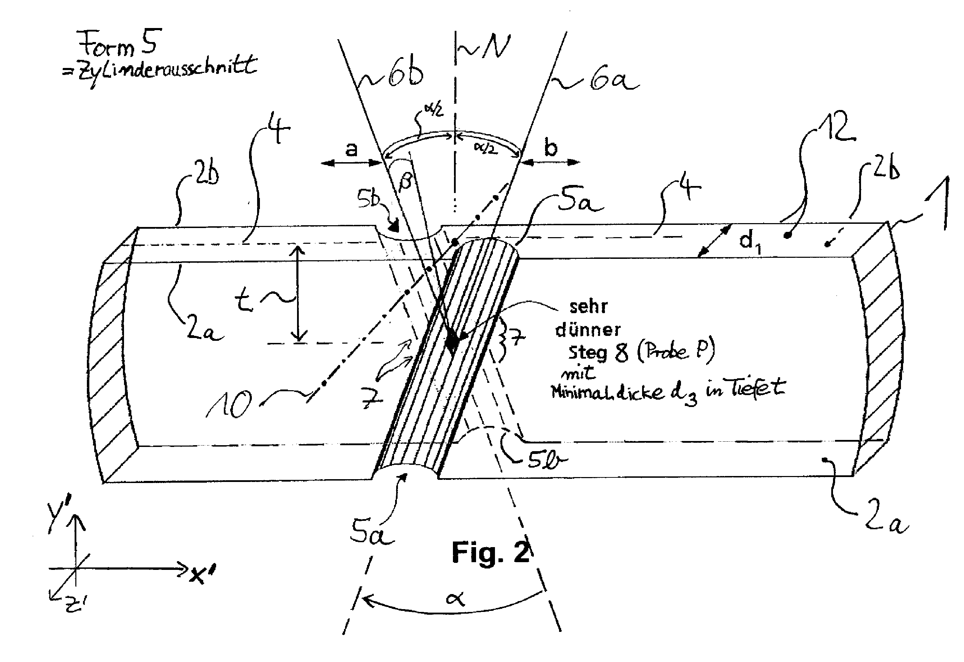

Figur 2 zeigt wie der in Figur 1 gezeigte Scheibenausschnitt 1 durch Bestrahlen mit einem fokussierten Laserstrahl 3 (vergleiche auch Figur 4) auf beiden Seiten mit jeweils einer Vertiefung 5 versehen wird, indem mit dem Laserstrahl parallel zur zentralen Scheibenebene 4 der Scheibe 1 eingestrahlt wird. Die zentrale Scheibenebene 4 ist hier als die mittig zwischen den beiden Oberflächen 2a und 2b der Scheibe 1 und parallel zu diesen verlaufende Ebene definiert. Die stirnseitige Schmalfläche 12 des Scheibenabschnitts 1 verläuft hier senkrecht zu den beiden Oberflächen 2a, 2b und der zentralen Scheibenebene 4. Das mit der Scheibe 1 ortsfest verbundene kartesische Koordinatensystem ist hier durch die drei Raumkoordinaten x', y' und z' gekennzeichnet.

Wie Figur 2 zeigt, wird zunächst mit dem Laserstrahl 3 (in Fig. 2 nicht zu sehen, vgl. Fig. 4) entlang der dem Betrachter zugewandten Oberfläche 2a der Scheibe 1 (also parallel zur Scheibenebene 4) so eingestrahlt, dass in diese Oberfläche 2a eine im Querschnitt senkrecht zu ihrer Längsachsrichtung 6a kreissegmentförmige Vertiefung 5a eingebracht wird. Diese Vertiefung wird hier (in Bezug auf die Oberfläche bzw. in Richtung senkrecht zur Scheibenebene 4 bzw. in z'-Richtung gesehen) mit einer maximalen Tiefe von Δt = 47,5 µm eingebracht. Wie die Figur weiter zeigt, erfolgt das Einbringen so, dass die Längsachse 6a der Vertiefung 5a parallel zur zentralen Scheibeneben 4 liegt und gegenüber der Normalen N der stirnseitigen Schmalfläche 12 um einen Winkel α/2 von hier 15° geneigt ist.

In ganz analoger Weise wird auf der der Vorderseite 2a gegenüberliegenden Rückseite 2b eine zweite Vertiefung 5b eingebracht. Hierzu wird nach dem Einbringen der ersten Vertiefung 5a die Scheibe 1 entsprechend um den Winkel α gedreht (vergleiche in Figur 4 gezeigte Positioniereinrichtung 11). Auch diese von der Rückseite eingebrachte Vertiefung 6b weist eine maximale Tiefe in Richtung senkrecht zur zentralen Scheibenebene 4 von Δt = 47.5 µm auf. Die zweite Vertiefung 5b (bzw. deren Längsachse 6b) verläuft nun zwar ebenfalls parallel zur Scheibenebene 4, jedoch gegenüber der ersten Vertiefung 5a. bzw. deren Längsachse 6a um einen Winkel α = 30° verdreht (das heißt, die zweite Vertiefung 5b wurde bezüglich ihrer Längsachse 6b ebenfalls mit einem Winkel von α/2 zur Normalen N einstrukturiert, jedoch gegenüber der Normalen N in die entgegengesetzte Richtung wie die Längsachse 6a gekippt).

Durch das vorbeschriebene Vorgehen wurde somit (in Normalrichtung N gesehen) in einer Tiefe von t entsprechend der halben Ausdehnung des Scheibenabschnitts 1 in Normalenrichtung N (hier: t ≈ 300 µm) in einem Schnittbereich 7, in dem sich die beiden eingebrachten Vertiefungen schneiden, ein sehr dünner Steg 8 erzeugt, der nach einem weiteren Abdünnschnitt mittels Ionenstrahlätzen (oder bei geeignet hoher Spannung im TEM auch bereits ohne diesen zusätzlichen Abdünnschritt) als elektronenstrahltransparente Probe P verwendet werden kann. Aufgrund der vorbeschriebenen Geometrien weist dieser Steg bzw. dieser im Kreuzungsbereich zwischen den beiden Vertiefungen 5a, 5b stehen gebliebene, hier spiegelsymmetrisch zur zentralen Scheibenebene 4 ausgebildete Materialabschnitt 8 eine minimale Dicke d₃ (gesehen in Richtung senkrecht zur zentralen Scheibenebene 4 bzw. in z'-Richtung) von d₃ = d₁ - 2 x Δt = 100 µm - 2 x 47.5 µm = 5 µm auf (Δt = maximale Einbringtiefe der beiden Vertiefungen 5a, 5b in z' -Richtung).

Die Hauptrichtungen 6a, 6b der beiden eingebrachten Vertiefungen 5a, 5b verlaufen somit nicht parallel, sondern schließen den Winkel α = 30° (der selbstverständlich auch größer oder kleiner als 30° gewählt werden kann) ein. Im Überlagerungsbereich bzw. Schnittbereich 7 der beiden Vertiefungen 5a und 5b entsteht der sehr dünne Materialabschnitt 8 mit einer minimalen Restdicke von hier 5 µm (es sind jedoch, bei geeignet exakter Strahlführung und Positioniergenauigkeit in der verwendeten Vorrichtung, vergleiche Figur 4, erfindungsgemäß auch geringere Restdicken d₃ im Bereich zwischen 0.5 und 2 µm erzielbar).

Wie bereits beschrieben, ist der dünne Materialabschnitt 8 für hinreichend hohe TEM-Energien bereits elektronenstrahltransparent oder kann durch das nachfolgend noch beschriebene zusätzliche Ionenstrahlätzen I weiter in seiner Dicke verringert werden, so dass auch für niedrige TEM-Energien Elektronenstrahltransparenz erzielt werden kann.

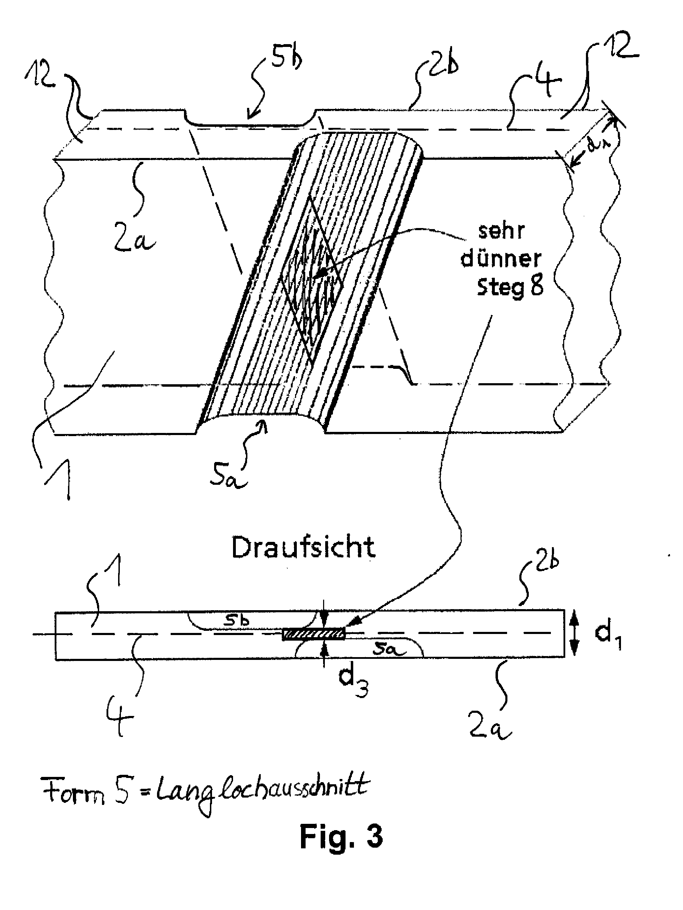

Durch die gekreuzte 7 Anordnung der Vertiefungen 5 gewinnt die Gesamtstruktur substantiell an Verwindungssteifigkeit, so dass im Überlagerungsbereich 7 der beiden Vertiefungen 5 geringe Materialrestdicken d₃ erzielt werden können. Die Erzeugung der Vertiefungen 5a, 5b erfolgt dabei vorzugsweise mit einem Ultrakurzpulslaser 14, wobei der Strahl mithilfe eines Wendelbohrkopfes 9 (vergleiche Figur 4) oder einer Trepanieroptik so aufbereitet wird, dass damit perfekt zylindrische Löcher (von denen wie gezeigt lediglich ein Kreissegmentabschnitt tatsächlich aus dem Material der Scheibe 1 herausstrukturiert wird) mit Lochdurchmessern von beispielsweise 100 oder 250 µm gebohrt werden können. Entsprechend ist auch das Einbringen von Langlöchern möglich (Figur 3). Der Einsatz eines Ultrakurzpulslasers 14 bietet aufgrund der leicht erzielbaren Multiphotonenabsorption die Möglichkeit, unabhängig von der Transparenz des bearbeiteten Materials der Scheibe 1 für die eingesetzte Wellenlänge zu arbeiten. Es ist jedoch auch denkbar, Kurzpulslaser mit Pulsen im Nanosekundenbereich einzusetzen, allerdings ist hier zu akzeptieren, dass durch die weiter ausgedehnte Wärmeeinflusszone (pro Seite 2a, 2b einige Mikrometer) die Mikrostruktur des Präparats modifiziert wird.

Wie Figur 2 desweiteren zeigt, erfolgt das Einbringen der Vertiefungen erst nach der Montage der Scheibe 1 (vergleiche Figur 4) auf eine Drehachse 10. Dies dient dazu, die Position und Orientierung der Scheibe 1 im Raum x, y, z (siehe Fig. 4) mit der Positioniereinrichtung 11 so einstellen zu können, dass der Strahl 3 in Bezug auf die Scheibe 1 gesehen an einem vordefinierten Ort fokussiert in die Scheibe 1 eintritt. Dieser Ort kann dann (z.B. mit einer Genauigkeit von < 10 µm) insbesondere auf der Stirnfläche 12, jedoch auch unterhalb derselben, d.h. im Inneren der Scheibe 1 liegen. Basierend auf präzisen Abstandsmessungen kann ggf. nachfokussiert werden. Diese Drehachse 10 sei hier zur vereinfachten Darstellung als in z' -Richtung verlaufende Achse, die durch die obere Stirnfläche 12 verläuft, angenommen. Die Achse 10 schneidet dabei die Normale N, also die Winkelhalbierende zwischen den beiden Längsachsen 6a, 6b, liegt also in Tiefenrichtung t bzw. in y'-Richtung gesehen genau oberhalb des Zentrums des Schnittbereichs 7 bzw. des herausgearbeiteten Materialabschnitts 8. Die Achse 10 wird hier z.B. als euzentrische Achse gewählt.

Durch die Wahl des Kreuzungswinkels α und der Bearbeitungspositionen auf beiden Seiten des Stegs 8 (in Figur 2 als "a" und "b" bezeichnet) kann in Bearbeitungsrichtung der Überlappungsbereich 7, und somit der nach dem Bearbeiten stehen bleibende Materialabschnitt 8, in der gewünschten Tiefe t positioniert werden. Dadurch können sowohl vergrabene Strukturen (wie beispielsweise Grenzflächen von Waververbünden) erschlossen, als auch oberflächennahe Bereiche zielpräpariert werden. Für die Präparation von Verbünden unterschiedlicher Abtragsraten ist eine Präparation aus Richtung des Materials mit der geringeren Abtragsrate vorteilhaft.

Durch die Positionierung auf der weitgehend euzentrischen Drehachse 10 besteht ferner die Möglichkeit, sogenannte "Curtaining"-Effekte (d.h. unerwünschte Grenzflächenwelligkeiten oder andere Artefakte der Oberflächen der Vertiefungen) durch eine Laserbearbeitung bei einem zusätzlichen Versetzen der Scheibe 1 während des Einbringens der Vertiefungen 5 in Dreh- und/oder Schwingbewegungen weitgehend zu reduzieren. Typische Oszillationswinkel β für eine solche zusätzliche Schwing- und/oder Drehbewegung der Scheibe 1 betragen ± 5 bis 10°. Zum exakten Positionieren der Scheibe 1 relativ zum einfallenden Laserstrahl 3 ist ein präzises 5-Achssystem vorteilhaft, wobei mit den Achsen x, y und z dieses Systems (Figur 4) die Positionierung der Bearbeitungsposition und die Festlegung der Bearbeitungstiefe t erfolgen kann und die euzentrische Drehachse 10 (Drehachse und mitbewegte weitere Linearachse, vergleiche hierzu auch Figur 4) dafür sorgt, dass bei einem zusätzlichen Schwingen und/oder Drehen der Scheibe 1 die Oszillation um den Winkel β möglichst genau um den Schnittpunkt 7 der beiden Vertiefungen 5a, 5b erfolgt.

In einer bevorzugten Ausführung des gezeigten Verfahrens werden die sich kreuzenden Vertiefungen 5a, 5b mit einer so niedrigen Laserfluenz strukturiert, dass strukturelle Schädigungen (Defektbildung durch den Rückschlagdruck bei der Ablation) effektiv unterbunden werden. Beispielsweise kann eine Pulsenergie von 33 oder 100 µJ verwendet werden. Da aber auch bei geringer Laserleistung (Fluenz knapp oberhalb der Multipuls-Ablationsfluenz) ein ca. 0.1 µm dicker, oberflächennaher Bereich in den stehenbleibenden Wänden der Vertiefungen 5a, 5b (also auch in den in Bezug auf die Ebene 4 gesehen außenliegenden Bereichen des Materialabschnitts 8) geschädigt wird, erfolgt vorteilhafterweise nach der geschilderten Mikrobearbeitung als Vorstufe ein weiterer, sich anschließender Ionenstrahlätzschritt unter streifendem Einfall in die Vertiefungen 5a, 5b.

Durch die vorbeschriebene laserbasierte Mikrobearbeitung ergeben sich je nach Wahl der Vertiefungsbreite (vergleiche auch Figur 3) parallel zur Ebene 4 gesehen sehr ausgedehnte Abdünnbereiche 8 (hier ca. 100 x 100 µm² oder 50 x 50 µm²) . Dabei ist die Wahl der maximalen Querschnittsausdehnung der Vertiefungen in der Ebene 4 (ggf. kann diese auch auf beiden Seiten des Stegs 8 bzw. auf beiden Oberflächen 2a, 2b unterschiedlich erfolgen) eine für das jeweils zu präparierende Material 1 zu optimierende Größe.

Auf die beschriebene Art und Weise können Materialrestdicken d₃ der Materialabschnitte 8 im Bereich von 5 µm oder weniger realisiert werden, ohne dass die Stege 8 einer massiven mechanischen Belastung ausgesetzt werden. wie Figur 3 in einem weiteren Ausführungsbeispiel zeigt (gleiche Bezugszeichen bezeichnen hier identische Merkmale wie in Figur 2; der untere Teil der Figur 3 zeigt eine Draufsicht in Richtung der Normalen N) lassen sich als Vertiefungen 5a, 5b, besonders bevorzugt Langlöcher mit einem im Vergleich zu Figur 2 (parallel zur Ebene 4 und senkrecht zur Längsachsrichtung der Vertiefungen gesehen) vergrößerten maximalen Querschnitt einbringen. Dies hat im Vergleich zum in Figur 2 gezeigten Fall den Vorteil, dass die Ausdehnung bzw. die Fläche der Materialabschnitte 8 in der Scheibenebene 4 größer ist. Die Langlöcher können beispielsweise einfach dadurch eingebracht werden, dass die Scheibe 1 während des Einbringens einer Vertiefung 5 unter Beibehaltung der Fokussierung des Laserstrahls in x-Richtung bewegt wird (vergleiche Figur 4).

Figur 4 zeigt ein Beispiel für eine erfindungsgemäße Vorgehensweise, mit der die in den Figuren 1 bis 3 beschriebenen Strukturierungen durchgeführt werden können. Auch hier bezeichnen identische Bezugszeichen im Vergleich zu Figuren 1 bis 3 identische Merkmale der Erfindung. Das kartesische Raumkoordinatensystem x, y und z bezeichnet hier das Weltkoordinatensystem, in dem die Scheibe 1 (mit ihrem Koordinatensystem x', y', z') mittels der angedeuteten Probenhalterung (die die nachfolgend beschriebene Positioniereinrichtung 11 umfasst) positioniert und orientiert werden kann.

Die zu dieser Vorgehensweise erfindungsgemäß verwendete Vorrichtung umfasst zunächst eine analog wie in DE 10 2008 000 306 A1 ausgebildete Strahlerzeugungseinheit 15 oder auch einen anderen Wendelbohr- oder Trepanierkopf, bei der ein in einem Pikosekundenlaser 14 erzeugter Laserstrahl über einen Spiegel 33 und eine Strahlversatzplatte 32 in ein geeignetes Prisma 30 geführt wird. Der Spiegel 33, die Strahlversatzplatte 32 und das Prisma 30 bilden hier die wesentlichen Bauteile des Wendelbohrkopfes 9. Der aus dem Wendelbohrkopf 9 austretende, zum Einbringen der Vertiefungen vorgesehene Laserstrahl 3, dessen Hauptstrahlrichtung mit E gekennzeichnet ist, kann durch den gezeigten Wendelbohrkopf 9 relativ zur Einstrahlrichtung E gesehen sowohl in eine Taumelbewegung PT als auch in eine Rotation R in sich selbst versetzt werden. Eine Rotation in sich selbst ist dabei aber nicht unbedingt erforderlich. Dies befähigt den Laserstrahl 3 (bei relativ dazu feststehender Scheibe 1) zum Einbringen exakt zylinderförmiger oder langlochförmiger Vertiefungen 5.

Die Positionierung und Orientierung der Scheibe 1 im bzw. relativ zum Strahl 3 erfolgt durch eine 5-Achs-Positioniereinrichtung 11 der skizzierten Probenhalterung in Form eines euzentrischen 5-Achs-Goniometers. Diese umfasst eine in den drei Raumrichtungen x, y und z nahezu frei bewegliche, hier mit dem Bezugszeichen 20 angedeutete 3-Achsen-Verschiebetischeinheit. Auf dieser Verschiebetischeinheit 20 ist eine eine Rotationsbewegung ermöglichende Vorrichtung 21 fixiert, mittels deren Rotationseinheit 22 die auf einer Halterung 24 der Rotationseinheit 22 fixierte Scheibe 1 um die hier senkrecht zur dargestellten Schnittebene x, y (also in z-Richtung) verlaufende Rotationsachse r gedreht werden kann. Diese Rotationsachse r stellt somit die vierte Achse der gezeigten Positioniereinrichtung 11 dar.

Die Rotationseinheit 22 weist darüber hinaus eine hier als Spindelantrieb ausgebildete Linearachseinheit 23 auf, mit der eine zum Zentrum der Eulerwiege bzw. zur Rotationsachse r hin gerichtete Translationsbewegung (Translationsrichtung bzw. fünfte Achse der gezeigten Positioniereinrichtung 11) realisiert werden kann.

Das Einstellen der Fokusposition des Strahls 3 über den Wendelbohrkopf 9 erfolgt synchronisiert mit der Bewegung der Scheibe 1 durch die 5-Achs-Positioniereinrichtung 11, so dass das vorbeschriebene fokussierte Eindringen des Strahls 3 an einem bevorzugt auf der stirnseitigen Randfläche 12 liegenden Bezugspunkt der Scheibe 1 erfolgt.

Wie Figur 4 rechts skizziert, umfasst die gezeigte Vorrichtung (die hier vereinfacht als ein einziges Gerät gezeichnet ist; in der Praxis umfasst diese Vorrichtung in der Regel getrennt voneinander eine Laserstrahleinheit 15 und eine Ionenstrahleinheit) zudem eine Breitstrahlionenquelle 13, mit der nach dem erfolgten Einbringen der Vertiefungen 5 ein weiteres Abdünnen des im Schnittbereich 7 erzeugten dünnen Steges 8 erfolgen kann. Hierzu wird die Scheibe 1 zunächst mit dem 3-Achs-Positioniertisch der Positioniereinrichtung 11 lateral aus dem Einstrahlbereich des Laserstrahls 3 (hier: in x-Richtung) verfahren. Sobald die Scheibe 1 aus der Laserbearbeitungsposition 16 in eine geeignete Position im Einstrahlbereich der Ionenquelle 13 verfahren ist (angedeutete Position 16'), beginnt die Ionenstrahlätzung I. Diese kann wie vorbeschrieben durchgeführt werden.

Alternativ dazu (hier nicht gezeigt) kann die erfindungsgemäß für das Verfahren verwendete Vorrichtung auch so realisiert werden, dass die Ionenquelle 13 und der Wendelbohrkopf 9 auf ein und denselben Bearbeitungsbereich ausgerichtet sind, die Scheibe 1 zwischen dem Laserbearbeitungsschritt und dem Ionenbearbeitungsschritt also nicht verfahren werden muss.

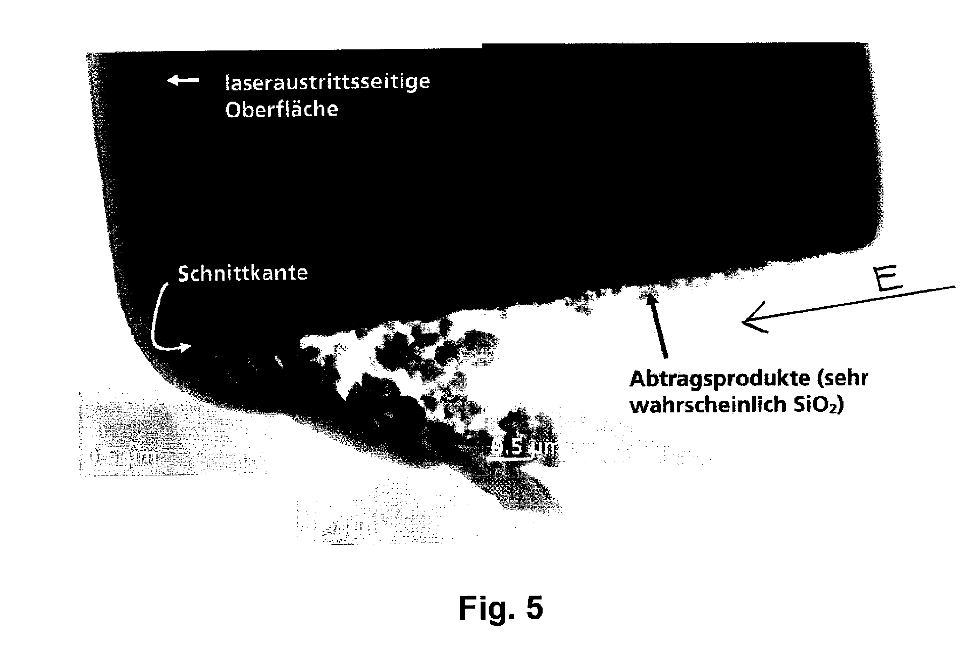

Figur 5, bei der E erneut die Einstrahlrichtung des Laserstrahls 3 zeigt, motiviert den Vorteil eines zusätzlich durchgeführten Ionenstrahlätzschrittes I nach der Laserbearbeitung: In der wissenschaftlichen Fachliteratur ist beschrieben, dass selbst durch Femtosekundenlaserbearbeitung etwa 1 bis 2 µm weit in das Materialinnere der bearbeiteten Struktur 1 hineinreichende Zonen struktureller Schädigung entstehen können (vgl. Y.N. Picard, S.M. Yalisove, Appl. Phys. Lett. 92 (2008), 014102). In der Regel treten jedoch bei Bulkmaterialien wie beispielsweise Silizium (in Figur 5 gezeigt) bei der Bearbeitung mit einem Wendelbohrkopf 9 in Kombination mit einem Pikosekundenlaser 14 lediglich strukturelle Schädigungen auf, die nicht nur gering sind, sondern auf einem wandnahen Bereich beschränkt sind, der sich maximal 100 nm ins Innere der bearbeiteten Struktur 1 erstrecken. Bei diesen in der Regel weniger als 100 nm ausgedehnten oberflächennahen Schädigungen handelt es sich beispielsweise um Amorphisierungen, die mit großer Wahrscheinlichkeit auf die Wechselwirkung der Oberfläche mit dem auch aus der Austrittsseite heraustretenden Ablationsplasma zurückzuführen sind. Ferner ist im in Figur 5 gezeigten Fall an der eigentlichen Schnittkante eine ca. 200 nm dicke Schicht aus Abtragsprodukten (sehr wahrscheinlich SiO₂) auszumachen. Unter dieser Schicht verborgen gibt es noch eine maximal 100 nm dicke Schicht, in der strukturelle Schädigungen des Siliziumsubstrats nicht ausgeschlossen werden können.

Es kann daher sinnvoll sein, vor der Untersuchung der herausstrukturierten Probe bzw. des entsprechenden Materialabschnitts 8 diese weniger als 100 nm bis ca. 200 nm dicken Schichtabschnitte zu entfernen, um Artefakte durch die Laserbearbeitung bei der TEM zu vermeiden. Hierzu kann das weitere Abdünnen der Dicke d₃ des verbleibenden Materialabschnitts 8 auf eine reduzierte minimale Dicke d_{3+I} durch zusätzliches Ionenstrahlätzschritt I dienen. Ohne diesen zusätzlichen Ionenstrahlätzen I würde sich sonst möglicherweise ein verschlechtertes, verschleiertes Abbild des Materialabschnitts 8 im TEM bieten.

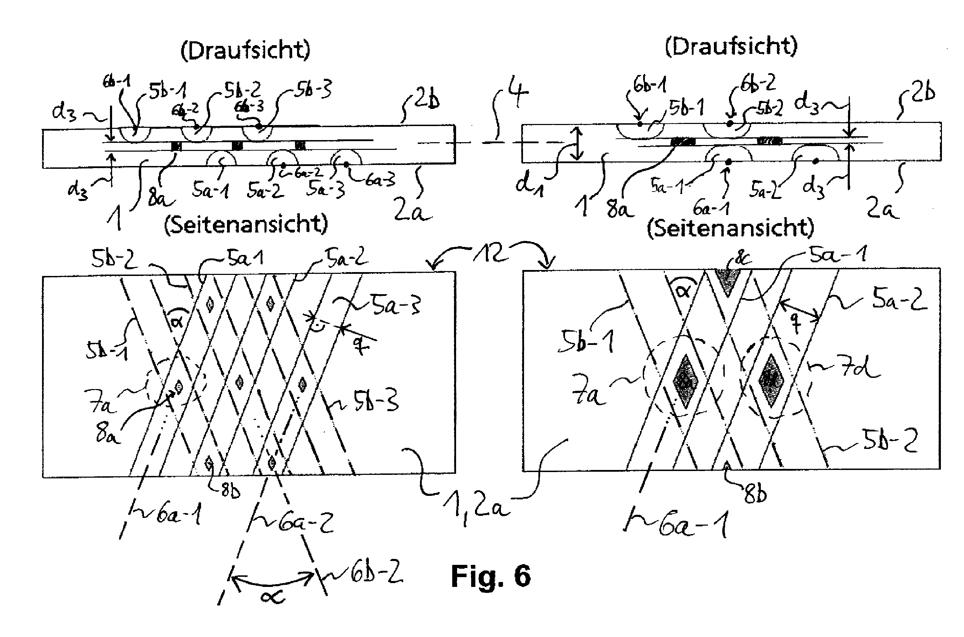

Figur 6 zeigt ein weiteres Ausführungsbeispiel, bei dem erfindungsgemäß ganz analog zu den in Figuren 2 und 3 gezeigten Fällen eine Mehrzahl von Vertiefungen in jede der beiden Oberflächen 2a, 2b der Scheibe 1 einstrukturiert werden. Auch hier bezeichnen identische Bezugszeichen identische Merkmale der Erfindung.

Wie Figur 6 links andeutet, werden im gezeigten Fall in die vordere Oberfläche 2a der Scheibe 1 mehrere einzelne, mit ihren jeweiligen Längsachsen 6a-1, 6a-2, ... jeweils parallel zueinander und parallel zur zentralen Scheibenebene 4 verlaufende einzelne Vertiefungen 5a-1, 5a-2, ... einstrukturiert.

Ebenso werden in die Rückseite 2b der Scheibe 1 mehrere mit ihren Längsachsen 6b-1, ... parallel zueinander und parallel zur Ebene 4 verlaufende einzelne Vertiefungen 5b-1, ... einstrukturiert. Die Einstrukturierung der Vertiefungen der Vorderseite 2a erfolgt dabei in Bezug auf diejenigen der Rückseite 2b entsprechend des in Figur 2 gezeigten Falls unter dem gemeinsamen vordefinierten Winkel α, der hier ebenfalls ca. 30° beträgt.

Es entstehen somit eine Vielzahl von Schnittbereichen 7a, 7b, ... , in denen sich die einzelnen Vertiefungen der vorder- und der Rückseite unter dem Winkel α kreuzen und in denen jeweils bereits elektronentransparente (ggf. auch erst nach dem zusätzlichen Ionenstrahlabdünnen) Materialabschnitte 8a, 8b, ... , stehen bleiben. Figur 6 links zeigt dabei das Einbringen von im Querschnitt zylinderabschnittsförmi.gen Vertiefungen 5, Figur 6 rechts zeigt das Einbringen von Langlöchern. Im Vergleich zu Figur 6 links wurde in Figur 6 rechts somit der maximale Querschnitt q der eingebrachten Vertiefungen 5 in Richtung senkrecht zur Längsachsrichtung 6 und in der Ebene 4 vergrößert. Durch geeignete Wahl dieses maximalen Querschnitts q lässt sich somit die Flächengröße der Materialabschnitte 8 in der zentralen Scheibenebene 4 wie gewünscht einstellen.

Die maximale Einbringtiefe Δt der Vertiefungen 5a in der Vorderseite 2a und der Vertiefungen 5b in der Rückseite 2b ist hier (senkrecht zur Ebene 4 gesehen) wiederum wie im in Figur 2 gezeigten Fall Δt = (d₁ - d₃) /2.

Figur 6 zeigt somit, dass nicht nur einzelne Scharten auf der Vorder- und der Rückseite der Scheibe 1 eingebracht werden können, sondern auch eine Vielzahl von Vertiefungen in Form mäandrierender Trajektorien, so dass eine Vielzahl entsprechender Abdünnareale 8, die in den Überlappungsbereichen 7 jeweils lediglich einige wenige Mikrometer dick d₃ sind, erzeugt werden kann.

Für die weitere Ionenstrahlabdünnung der laserbasiert erzeugten Materialabschnitte 8 kommen (in Figur 4 nicht gezeigt) hier vorzugsweise zwei Ionenquellen zum Einsatz, die unter flachem Winkel (beispielsweise 4° bis 10°) von der Vorder- und der Rückseite (vergleiche die in Figur 2 obenliegende Schmalseite 12 sowie die gegenüberliegende Unterseite) die eingebrachten Vertiefungen 5 soweit nachdünnen wie gewünscht, bis also z.B. die amorphisierten Bereiche entfernt sind oder auch für niedrige Elektronenenergien Elektronenstrahltransparenz erreicht wird. Vorzugsweise scheinen die beiden Ionenquellen nur innerhalb eines stark eingeschränkten Winkelbereichs (abhängig von der maximalen Vertiefungsbreite q) entlang der Vertiefungen, also in Längsachsrichtung 6, um Redepositionen zu vermeiden. Die Anordnung der schartenartigen Vertiefungen kann dem Abdünnprozess Rechnung tragen und so einen unblockierten Angriff des Ionenstrahls von typischerweise 0.5 mm Halbwertsdurchmesser bieten.

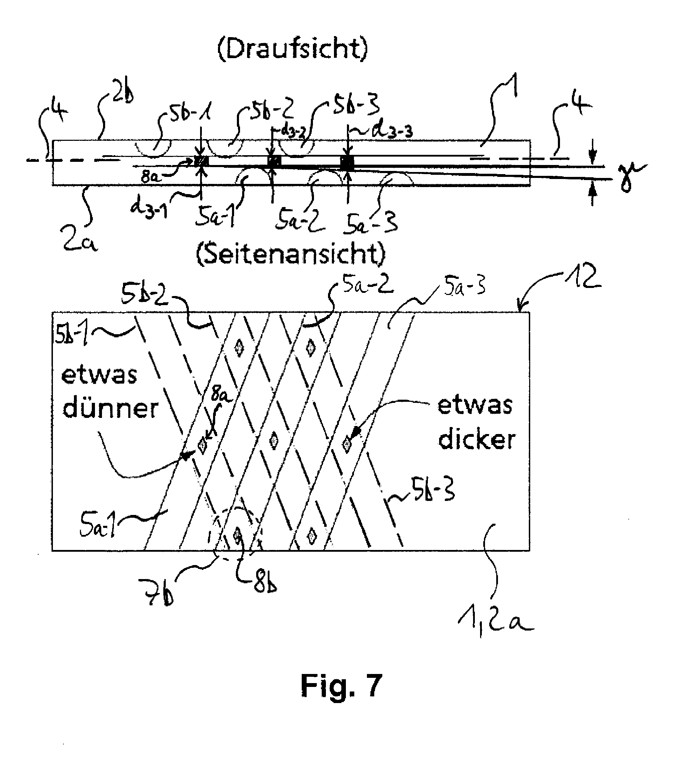

Figur 7 zeigt schließlich ein weiteres Ausführungsbeispiel, das ein entsprechendes erfindungsgemäßes Vorgehen der laserbasierten Strukturierung wie in Figur 6 zeigt, so dass nachfolgend lediglich die Unterschiede beschrieben werden.

Während die rückseitigen 2b Vertiefungen 5b in Figur 7 wie im in Figur 6 gezeigten Fall eingebracht werden, erfolgt (durch geeignete Bewegung der Scheibe 1 mittels der Positioniereinrichtung 11 zwischen dem Einbringen der einzelnen vorderseitigen 2a Vertiefungen 5a) ein Einbringen der vorderseitigen 2a Vertiefungen 5a mit unterschiedlicher maximaler Einbringtiefe Δt (senkrecht zur Ebene 4 gesehen). Die Scheibe 1 wird dabei relativ zur Ebene 4 gesehen durch die Positioniereinrichtung unter einem geringfügigen Winkel γ, der hier z.B. 2° beträgt, verfahren. Von Vertiefung zu Vertiefung auf der Vorderseite 2a nimmt somit die maximale Einbringtiefe Δt der Vertiefungen 5a-1, 5a-2 und 5a-3 ab. Entsprechend nimmt die minimale Dicke d₃ der entsprechend herausstrukturierten Materialabschnitte 8a, ... zu (die zunehmenden minimalen Dicken d₃ sind hier durch die Bezugszeichen d₃₋₁, d₃₋₂, d₃₋₃ gekennzeichnet).

Ein Herausarbeiten unterschiedlicher Dicken der Materialabschnitte 8 abhängig vom Winkel γ hat den Vorteil, dass beim nachfolgenden Ionenstrahlätzen I durch optische Betrachtung vom Benutzer leichter festgestellt werden kann, wann die reduzierte minimale Zieldicke der Probe 8 erreicht ist.

Schließlich kann erfindungsgemäß (nicht dargestellt) zur Vermeidung der in Figur 5 links erkennbaren Schädigungen durch laserein- und laseraustrittsseitigen Oberflächenangriff vor der Laserbearbeitung gemäß der Erfindung auch auf eine dem Laser während der Bearbeitung zuzuwendende respektive abzuwendende Oberfläche der Scheibe 1 eine Opferschicht (zum Beispiel aus einem leitenden Material wie Platin) aufgebracht werden, um diesen Bereich des Präparats vor einer strukturellen Beeinflussung durch das Ablationsplasma zu schützen.

## Patentansprüche

1. Verfahren zur Präparation einer Probe (P) für die Mikrostrukturdiagnostik, insbesondere für die Transmissionselektronenmikroskopie TEM, die Rasterelektronenmikroskopie oder die Röntgenabsorptionsspektroskopie,
wobei eine flache, planparallele Scheibe (1) entlang ihrer beiden gegenüberliegenden Oberflächen (2a, 2b) jeweils so mit einem Laserstrahl (3) bestrahlt wird, dass durch laserstrahlbedingten (3) Materialabtrag in diese beiden Oberflächen (2a, 2b) jeweils eine parallel zu einer zentralen Scheibenebene (4) verlaufende Vertiefung (5a, 5b) eingebracht wird, wobei diese zentrale Scheibenebene (4) eine Ebene ist, die parallel zu den beiden gegenüberliegenden Oberflächen (2a, 2b) der Scheibe (1) und zwischen diesen verläuft,
wobei diese beiden Vertiefungen (5a, 5b) beidseits dieser zentralen Scheibenebene (4) verlaufend so eingebracht werden, dass sich ihre Längsachsen (6a, 6b), bei Projektion dieser Längsachsen (6a, 6b) auf diese zentrale Scheibenebene (4) gesehen, unter einem vordefinierten Winkel α 2 10°, bevorzugt α ≥ 20°, bevorzugt α ≥ 30°, schneiden und dass im Schnittbereich (7) der beiden Vertiefungen (5a, 5b) zwischen diesen (5a, 5b) ein Materialabschnitt (8) vordefinierter minimaler Dicke *d₃*, gesehen senkrecht zu dieser zentralen Scheibenebene (4), als Probe (P) verbleibt.

2. Verfahren nach dem vorhergehenden Anspruch
***dadurch gekennzeichnet, dass***
der nach dem Einbringen der beiden Vertiefungen (5a, 5b) im Schnittbereich (7) derselben (5a, 5b) und zwischen diesen (5a, 5b) verbliebene Materialabschnitt (8) durch Ionenstrahlätzen (I) ausgehend von der vordefinierten minimalen Dicke *d₃* in seiner Dicke weiter verringert wird, also ausgedünnt wird auf eine reduzierte minimale Dicke *d_{3+I}* mit *d_{3+I}* < *d₃*, gesehen senkrecht zu der zentralen Scheibenebene (4),
wobei dieses Ionenstrahlätzen (I) bevorzugt gemäß einer, mehrerer oder aller der nachfolgenden Merkmale durchgeführt wird:
• unter in Bezug auf die zentrale Scheibenebene (4) streifendem Einfall in die Vertiefungen (5a, 5b),
• entweder mit einer Breitstrahl-Ionenquelle (13) oder mit einem fokussierten Ionenstrahl und/oder einer Ionenfeinstrahlanlage (FIB von englisch "Focused Ion Beam"),
und/oder
• mittels zweier Ionenquellen, bevorzugt zweier Breitstrahl-Ionenquellen, mit denen längs (6a, 6b) der eingebrachten Vertiefungen (5a, 5b) gesehen aus beiden Richtungen in die Vertiefungen (5a, 5b) eingestrahlt wird.

3. Verfahren nach einem der vorhergehenden Ansprüche
***dadurch gekennzeichnet, dass***
der Laserstrahl (3), insbesondere ein fokussierter Laserstrahl, beim Einbringen der Vertiefungen (5a, 5b) relativ zu seiner Einstrahlrichtung (E) gesehen in eine Taumelbewegung (PT) versetzt wird, bevorzugt darüber hinaus auch in eine Rotation (R) in sich selbst versetzt wird, um die Vertiefungen (5a, 5b) entlang ihrer Längsachsen (6a, 6b) gesehen mit konstantem Querschnitt, bevorzugt in Form eines Kreisausschnitts oder eines Langlochausschnitts, einzubringen
und/oder
dass das Einbringen der Vertiefungen (5a, 5b) durch bevorzugt mit einem Wendelbohrkopf (9) durchgeführtes Wendelbohren oder Wendelbohrschneiden oder mit Hilfe einer Trepanieroptik erfolgt.

4. Verfahren nach einem der vorhergehenden Ansprüche, bevorzugt nach dem vorhergehenden Anspruch,
***dadurch gekennzeichnet, dass***
die Scheibe (1) während des Einbringens der Vertiefungen (5a, 5b) in eine Dreh- und/oder Schwingbewegung (β) um eine Achse senkrecht zur zentralen Scheibenebene (4) versetzt wird.

5. Verfahren nach einem der vorhergehenden Ansprüche, bevorzugt nach einem der beiden vorhergehenden Ansprüche,
***dadurch gekennzeichnet, dass***
der Fokus des Laserstrahls (3) relativ zu einem Bezugspunkt der Scheibe (1), bevorzugt relativ zu einem auf einer stirnseitigen Schmalfläche (12) der Scheibe liegenden Bezugspunkt, auf einen vorbestimmten Abstand, bevorzugt auf einen Abstand von Null, eingestellt wird
und/oder
dass die Scheibe (1) vor dem und/oder während des Einbringen(s) der Vertiefungen (5a, 5b) auf einer Drehachse, bevorzugt auf einer euzentrischen Drehachse (10), positioniert wird
und/oder
dass die Scheibe (1) vor dem und/oder während des Einbringen(s) der Vertiefungen (5a, 5b) mittels einer 5-Achs-Positioniereinrichtung (11) oder einer 4-Achs-Positioniereinrichtung, bevorzugt mittels eines Dreiachsen-Verschiebetischs (Achsen x,y,z) mit einer Rotationsachse (Achse r) und einer Linearachse (Achse 1), positioniert wird.

6. Verfahren nach einem der vorhergehenden Ansprüche,
***dadurch gekennzeichnet, dass***
durch Bestrahlen (3) entlang der beiden Oberflächen (2a, 2b) der Scheibe (1) in diesen beiden Oberflächen (2a, 2b) jeweils mehrere Vertiefungen (5a-1, 5a-2, ..., 5b-1, 5b-2, ...) eingebracht werden,
wobei bevorzugt auf jeder der beiden Oberflächen (2a, 2b) diese Vertiefungen mit ihren Längsachsen (6a-1, 6a-2, ..., 6b-1, 6b-2, ...) jeweils parallel zueinander verlaufend eingebracht werden, so dass die Vertiefungen (5a-1, 5a-2, ...) der einen Oberfläche (2a) und diejenigen (5b-1, 5b-2, ...) der anderen Oberfläche (2b) sich jeweils unter dem vordefinierten Winkel α schneiden und somit mehrere solcher Schnittbereiche (7a, 7b, ...) mit verbleibenden, bevorzugt bereits elektronenstrahltransparenten Materialabschnitten (8a, 8b, ...) vordefinierter minimaler Dicke *d₃* entstehen.

7. Verfahren nach dem vorhergehenden Anspruch,
***dadurch gekennzeichnet, dass***
die Vertiefungen (5a-1, 5a-2, ...) mindestens einer der Oberflächen (2a) der Scheibe (1) in Richtung senkrecht zu der zentralen Scheibenebene (4) gesehen unterschiedlich tief in die betreffende Oberfläche (2a) eingebracht werden, wobei die Einbringtiefe bevorzugt von Vertiefung zu Vertiefung linear (γ) zu- oder abnimmt.

8. Verfahren nach einem der vorhergehenden Ansprüche,
***dadurch gekennzeichnet, dass***
die Vertiefungen (5a, 5b, 5a-1, ..., 5b-1, ...) so eingebracht werden, dass der/die verbleibende(n) Materialabschnitt (e) (8, 8a, 8b, ...) in vordefiniertem/n Abstand/Abständen (t) von einer stirnseitigen Schmalfläche (12) der Scheibe (1) entstehen
und/oder
dass die Vertiefungen (5a, 5b, 5a-1, ..., 5b-1, ...) unter einem Winkel α/2 mit α/2 ≥ 10°, bevorzugt α/2 ≥ 15° zur Normalen (N) einer stirnseitigen Schmalfläche (12) der Scheibe (1) eingebracht werden
und/oder
dass mehrere, bevorzugt alle Vertiefungen (5a, 5b, 5a-1, ..., 5b-1, ...) mit ihren Längsachsen (6a, 6b, 6a-1, ..., 6b-1, ...) parallel zu der zentralen Scheibenebene (4) verlaufend eingebracht werden und/oder
dass die Vertiefungen (5a, 5b, 5a-1, ..., 5b-1, ...) in Form eines Zylinderausschnitts oder eines Langlochausschnitts eingebracht werden.

9. Verfahren nach einem der vorhergehenden Ansprüche,
***dadurch gekennzeichnet, dass***
der/die verbleibende(n), bevorzugt bereits elektronenstrahltransparente(n) Materialabschnitt (e) (8, 8a, 8b, ...) (eine) vordefinierte minimale Dicke(n) *d₃* zwischen 0.3 µm und 10 µm, bevorzugt zwischen 0.5 µm und 5 µm, aufweist/aufweisen
und/oder
dass die maximale Querschnittsausdehnung (q) der Vertiefungen (5a, 5b) parallel zu der zentralen Scheibenebene (4) gesehen zwischen 50 µm und 500 µm, bevorzugt zwischen 100 µm und 200 µm, beträgt
und/oder
dass die maximale Einbringtiefe der Vertiefungen (5a, 5b) senkrecht zu der zentralen Scheibenebene (4) gesehen zwischen 20 µm und 100 µm, bevorzugt zwischen 40 µm und 50 µm, liegt.

10. Verfahren nach einem der vorhergehenden Ansprüche,
***dadurch gekennzeichnet, dass***
der Laserstrahl (3) fokussiert ist und/oder ein mittels eines Pikosekundenlasers (14) oder eines Femtosekundenlasers erzeugter Laserstrahl ist.

11. Verfahren nach einem der vorhergehenden Ansprüche,
***dadurch gekennzeichnet, dass***
die Scheibe (1) eine(n) mittlere(n) Ausdehnung, Durchmesser und/oder Kantenlänge von zwischen 1 mm und 5 mm, bevorzugt von 3 mm, eine mittlere Dicke *d₁* von zwischen 50 µm und 200 µm, bevorzugt von 100 µm, und/oder eine(n) mittlere(n) Ausdehnung, Durchmesser und/oder Kantenlänge, die/der mindestens das 15-fache, bevorzugt mindestens das 25-fache, ihrer mittleren Dicke *d₁* beträgt, aufweist
und/oder
dass die Scheibe (1) hergestellt wird durch mechanisches Schleifen, durch Sägen, durch Lasererosion oder durch Plasma-Funkenerosion.

12. Verfahren nach einem der vorhergehenden Ansprüche,
***dadurch gekennzeichnet, dass***
der Laserstrahl (3) mit einer Strahlungseinheit (15) erzeugt wird, und
dass eine Probenhalterung (11) zum Positionieren der
Scheibe (1) im Laserstrahl (3) verwendet wird.

## Claims

1. A method for preparing a sample (P) for microstructure diagnostics, in particular for transmission electron microscopy TEM, scanning electron microscopy or X-ray absorption spectroscopy,
wherein a flat, plane-parallel slice (1) is irradiated along each of its two opposing surfaces (2a, 2b) with a laser beam (3) such that as a result of erosion of material due to the laser beam (3) one depression (5a, 5b) running parallel to a central slice plane (4) in each case is introduced into these two surfaces (2a, 2b), this central slice plane (4) being a plane which runs parallel to the two opposing surfaces (2a, 2b) of the slice (1) and between them,
wherein these two depressions (5a, 5b) are introduced running on both sides of this central slice plane (4) such that their longitudinal axes (6a, 6b), viewed if these - longitudinal axes (6a, 6b) are projected onto this central slice plane (4), intersect at a predefined angle α ≥ 10°, preferably α ≥ 20°, preferably α ≥ 30°, and that in the region of intersection (7) of the two depressions (5a, 5b) a portion of material (8) of predefined minimum thickness d₃, viewed perpendicular to this central slice plane (4), remains as a sample (P) between said depressions (5a, 5b).

2. A method according to the preceding claim,
**characterised in that**
the portion of material (8) remaining after the introduction of the two depressions (5a, 5b) in the region of intersection (7) thereof (5a, 5b) and between them (5a, 5b) is further reduced in its thickness by ion beam etching (I) starting from the predefined minimum thickness d₃, i.e. is thinned out to a reduced minimum thickness d_{3+I} with d_{3+I}< d₃, viewed perpendicular to the central slice plane (4),
this ion beam etching (I) preferably being carried out in accordance with one, several or all of the following features:
• under glancing incidence, relative to the central slice plane (4), into the depressions (5a,5b),
• either with a broad-beam ion source (13) or with a focused ion beam and/or a focused ion beam system (FIB, from the English "focused ion beam"),
and/or
• by means of two ion sources, preferably two broad-beam ion sources, with which, viewed along (6a, 6b) the depressions (5a, 5b) which are introduced, irradiation is carried out into the depressions (5a, 5b) from both directions.

3. A method according to one of the preceding claims,
**characterised in** hat
the laser beam (3), in particular a focused laser beam, upon introduction of the depressions (5a, 5b), viewed relative to its direction of incidence (E), is set in a wobbling motion (PT), preferably furthermore is also caused to rotate (R) in itself, in order to introduce the depressions (5a, 5b), viewed along their longitudinal axes (6a, 6b), with a constant cross-section, preferably in the form of a circular cutout or an elongate-hole cutout,
and/or
**in that** the introduction of the depressions (5a, 5b) takes place by twist drilling or twist drill cutting preferably carried out with a twist drilling head (9), or with the aid of an optical trepanning system.

4. A method according to one of the preceding claims, preferably according to the preceding claim,
**characterised in that**
the slice (1) during the introduction of the depressions (5a, 5b) is set in a rotary and/or oscillating motion (β)about an axis perpendicular to the central slice plane (4).

5. A method according to one of the preceding claims, preferably according to one of the two preceding claims,
**characterised in that**
the focus of the laser beam (3) relative to a reference point of the slice (1), preferably relative to a reference point located on an end-face narrow face (12) of the slice, is set to a predetermined distance, preferably to a distance of zero,
and/or
**in that** the slice (1) before and/or during the introduction of the depressions (5a, 5b) is positioned on an axis of rotation, preferably on a eucentric axis of rotation (10),
and/or
**in that** the slice (1) before and/or during the introduction of the depressions (5a, 5b) is positioned by means of a 5-axis positioning means (11) or a 4-axis positioning means, preferably by means of a three-axis translation stage (axes x, y, z) with a rotary axis (axis r) and a linear axis (axis 1).

6. A method according to one of the preceding claims,
**characterised in that**
by irradiation (3) along the two surfaces (2a, 2b) of the slice (1) a plurality of depressions (5a-1 5a-2, ..., 5b-1 5b-2, ... in each case are introduced into these two surfaces (2a, 2b),
with preferably on each of the two surfaces (2a, 2b) these depressions being introduced with their longitudinal axes (6a-1 6a-2, ..., 6b-1 6b-2, ...) running in each case parallel to each other, so that the depressions (5a-1 5a-2, ...) of the one surface (2a) and those (5b- 1, 5b-2, ...) of the other surface (2b) intersect in each case at the predefined angle α and thus a plurality of such regions of intersection (7a, 7b, ...) are produced with remaining portions of material (8a, 8b, ...), which preferably are already transparent to electron beams, of a predefined minimal thickness d₃.

7. A method according to the preceding claim,
**characterised in that**
the depressions (5a-1, 5a-2, ...) of at least one of the surfaces (2a) of the slice (1), viewed in the direction perpendicular to the central slice plane (4), are introduced into the surface (2a) in question to different depths, the depth of introduction preferably increasing or decreasing linearly (γ) from depression to depression.

8. A method according to one of the preceding claims,
**characterised in that**
the depressions (5a, 5b, 5a-1,..., 5b-1, ...) are introduced such that the remaining portion(s) of material (8, 8a, 8b, ...) are produced at predefined distance(s) (t) from an end-face narrow face (12) of the slice (1)
and/or
**in that** the depressions (5a, 5b, 5a-1, ..., 5b-1, ...) are introduced at an angle α/2 with α/2 ≥ 10°, preferably α/2 ≥ 15°, to the normal (N) of an end-face narrow face (12) of the slice (1)
and/or
**in that** a plurality of, preferably all, the depressions (5a, 5b, 5a-1, ..., 5b-1,...) are introduced with their longitudinal axes (6a, 6b, 6a-1, ..., 6b-1, ...) running parallel to the central slice plane (4)
and/or
**in that** the depressions (5a, 5b, 5a-1, ..., 5b-1, ...) are introduced in the form of a cylindrical cutout or an elongate-hole cutout.

9. A method according to one of the preceding claims,
**characterised in that**
the remaining portion(s) of material (8, 8a, 8b, ...), which are preferably already transparent to electron beams, has/have (a) predefined minimal thickness(es) d₃ of between 0.3 µm and 10 µm, preferably between 0.5 µm and 5 µm,
and/or
**in that** the maximum cross-sectional extent (q) of the depressions (5a, 5b), viewed parallel to the central slice plane (4), is between 50 µm and 500 µm, preferably between 100 µm and 200 µm,
and/or
**in that** the maximum depth of introduction of the depressions (5a, 5b), viewed perpendicular to the central slice plane (4), lies between 20 µm and 100 µm, preferably between 40 µm and 50 µm.

10. A method according to one of the preceding claims,
**characterised in that**
the laser beam (3) is focused and/or is a laser beam generated by means of a picosecond laser (14) or a femtosecond laser.

11. A method according to one of the preceding claims,
**characterised in that**
the slice (1) has an average extent, diameter and/or edge length of between 1 mm and 5 mm, preferably of 3 mm, an average thickness d₁ of between 50 µm and 200 µm, preferably of 100 µm, and/or an average extent, diameter and/or edge length which is at least 15 times, preferably at least 25 times, its central thickness d₁,
and/or
**in that** the slice (1) is produced by mechanical grinding, by sawing, by laser erosion or by plasma electrical discharge machining.

12. A method according to one of the preceding claims,
**characterised in that**
the laser beam (3) is generated with a radiation unit (15), and
**in that** a sample holding means (11) is used for positioning the slice (1) in the laser beam (3).

## Revendications

1. Procédé de préparation d'un échantillon (P) pour le diagnostic d'une microstructure, en particulier pour la microscopie électronique par transmission (MET), la microscopie électronique par balayage ou la spectroscopie d'absorption X,
dans lequel une lame plate à faces parallèles (1) est irradiée respectivement le long de ses deux surfaces situées en opposition (2a, 2b) avec un faisceau laser (3) de telle sorte qu'une cavité (5a, 5b) s'étendant parallèlement à un plan central de la lame (4) est pratiquée respectivement dans ces deux surfaces (2a, 2b) à la suite de l'enlèvement de matière provoqué par le faisceau laser (3), ce plan central de la lame (4) étant un plan qui s'étend parallèlement aux deux surfaces situées en opposition (2a, 2b) de la lame (1) et entre celles-ci,
dans lequel ces deux cavités (5a, 5b) sont pratiquées de façon à s'étendre de part et d'autre de ce plan central de la lame (4) de telle sorte que leurs axes longitudinaux (6a, 6b), considérés dans une projection de ces axes longitudinaux (6a, 6b) sur ce plan central de la lame (4), s'entrecoupent dans un angle prédéfini α ≥ 10°, de préférence α ≥ 20°, et de préférence α ≥ 30° et que dans la zone de coupe (7) des deux cavités (5a, 5b), il subsiste entre ces deux cavités (5a, 5b) une section de matière (8) d'une épaisseur minimale prédéfinie d₃, considérée perpendiculairement à ce plan central de la lame (4), en tant qu'échantillon (P).

2. Procédé selon la revendication précédente,
**caractérisé**
**en ce que** la section de matière (8) subsistant après la réalisation des deux cavités (5a, 5b) dans la zone de coupe (7) de celles-ci (5a, 5b) et entre celles-ci (5a, 5b) est encore réduite dans son épaisseur, à partir de l'épaisseur minimale prédéfinie d₃, par une érosion à faisceau ionique (I), c'est-à-dire amincie jusqu'à une épaisseur minimale réduite d_{3+I}, où d_{3+I} < d₃ considéré perpendiculairement au plan central de la lame (4),
cette érosion par faisceau ionique (I) étant de préférence exécutée selon l'une, plusieurs ou la totalité des caractéristiques suivantes :
- avec une incidence dans les cavités (5a, 5b) en effleurement par rapport au plan central de la lame (4),
- soit avec une source d'ions à faisceau large (13), soit avec un faisceau d'ions focalisé et/ou un dispositif à faisceau fin d'ions (FIB, d'après l'anglais « Focused Ion Beam »),
et/ou
- au moyen de deux sources d'ions, de préférence deux sources d'ions à faisceau large, avec lesquelles, considéré le long (6a, 6b) des cavités (5a, 5b) pratiquées, les faisceaux sont projetés dans les cavités (5a, 5b) à partir de deux directions.

3. Procédé selon l'une des revendications précédentes,
**caractérisé**
**en ce que** le faisceau laser (3), en particulier un faisceau laser focalisé, est décalé dans un mouvement de nutation (PT) lors de la réalisation des cavités (5a, 5b), considéré par rapport à sa direction de projection (E), et de préférence, il est également décalé sur lui-même dans une rotation (R) afin de pratiquer les cavités (5a, 5b), considérées le long de leurs axes longitudinaux (6a, 6b), avec une section constante, de préférence sous la forme d'un secteur de cercle ou de trou oblong,
et/ou
**en ce que** la réalisation des cavités (5a, 5b) est effectuée par un forage hélicoïdal exécuté de préférence avec une tête de forage hélicoïdal (9) ou par taillage de forage hélicoïdal ou à l'aide d'un dispositif optique de trépanation.

4. Procédé selon l'une des revendications précédentes, et de préférence selon la revendication précédente,
**caractérisé**
**en ce que** la lame (1) est décalée dans un mouvement de rotation et/ou d'oscillation (β) autour d'un axe perpendiculaire au plan central de la lame (4) pendant la réalisation des cavités (5a, 5b).

5. Procédé selon l'une des revendications précédentes, et de préférence selon l'une des deux revendications précédentes,
**caractérisé**
**en ce que** la focalisation du faisceau laser (3) par rapport à un point de référence de la lame (1), et de préférence par rapport à un point de référence situé sur une surface étroite de la façade (12) de la lame, est réglée à une distance prédéterminée, et de préférence à une distance de zéro,
et/ou
**en ce que** la lame (1) est positionnée sur un axe de rotation, et de préférence sur un axe de rotation eucentromérique (10) avant et/ou pendant la réalisation des cavités (5a, 5b),
et/ou
**en ce que** la lame (1) est positionnée avec un axe de rotation (axe r) et un axe linéaire (axe I) au moyen d'un dispositif de positionnement à 5 axes (11) ou d'un dispositif de positionnement à 4 axes, et de préférence au moyen d'une table de déplacement à trois axes (axes x, y, z) avant et/ou pendant la réalisation des cavités (5a, 5b).

6. Procédé selon l'une des revendications précédentes,
**caractérisé**
**en ce que** plusieurs cavités (5a-1, 5a-2, ..., 5b-1, 5b-2, ...) sont pratiquées respectivement, par la projection d'un faisceau (3) le long des deux surfaces (2a, 2b) de la lame (1), dans ces deux surfaces (2a, 2b),
ces cavités étant de préférence pratiquées de façon à s'étendre respectivement avec leurs axes longitudinaux (6a-1, 6a-2, ..., 6b-1, 6b-2, ...) parallèles l'un à l'autre sur chacune des deux surfaces (2a, 2b) de telle sorte que les cavités (5a-1, 5a-2, ...) d'une surface (2a) et celles (5b-1, 5b-2, ...) de l'autre surface (2b) s'entrecoupent respectivement selon l'angle prédéfini a et que plusieurs telles zones de coupe (7a, 7b, ...) ayant des sections de matière (8a, 8b, ...) subsistantes, de préférence déjà transparentes aux faisceaux d'électrons, d'une épaisseur minimale prédéfinie d₃ sont ainsi créées.

7. Procédé selon la revendication précédente,
**caractérisé**
**en ce que** les cavités (5a-1, 5a-2, ...) d'au moins une des surfaces (2a) de la lame (1), considérées dans le sens perpendiculaire au plan central de la lame (4), sont pratiquées à des profondeurs différentes dans la surface (2a) concernée, la profondeur de réalisation augmentant ou diminuant de préférence de façon linéaire (γ) de cavité en cavité.

8. Procédé selon l'une des revendications précédentes,
**caractérisé**
**en ce que** les cavités (5a, 5b, 5a-1, ..., 5b-1, ... ) sont pratiquées de telle sorte que la ou les sections de matière (8, 8a, 8b, ...) subsistantes sont créées à une ou des distances prédéfinies (t) d'une surface étroite de la façade (12) de la lame (1),
et/ou
**en ce que** les cavités (5a, 5b, 5a-1, ..., 5b-1, ...) sont pratiquées dans un angle α/2, où α/2 ≤ 10°, et de préférence α/2 ≥ 15° par rapport à la normale (N) d'une surface étroite de la façade (12) de la lame (1),
et/ou
**en ce que** plusieurs, et de préférence toutes les cavités (5a, 5b, 5a-1, .... 5b-1, ...) sont pratiquées avec leurs axes longitudinaux (6a, 6b, 6a-1, .... 6b-1, ...) s'étendant parallèlement au plan central de la lame (4),
et/ou
**en ce que** les cavités (5a, 5b, 5a-1, ..., 5b-1, ...) sont pratiquées sous forme d'un secteur de cylindre ou d'un secteur de trou oblong.

9. Procédé selon l'une des revendications précédentes,
**caractérisé**
**en ce que** la ou les sections de matière (8, 8a, 8b, ...) subsistantes, de préférence déjà transparentes aux faisceaux d'électrons, présentent une ou des épaisseurs minimales prédéfinies d₃ comprises entre 0,3 µm et 10 µm, et de préférence entre 0,5 µm et 5 µm,
et/ou
**en ce que** l'extension maximale de la section (q) des cavités (5a, 5b), considérée parallèlement au plan central de la lame (4), est comprise entre 50 µm et 500 µm, et de préférence entre 100 µm et 200 µm,
et/ou
**en ce que** la profondeur de réalisation maximale des cavités (5a, 5b), considérée perpendiculairement au plan central de la lame (4), est comprise entre 20 µm et 100 µm, et de préférence entre 40 µm et 50 µm.

10. Procédé selon l'une des revendications précédentes,
**caractérisé**
**en ce que** le faisceau laser (3) est focalisé et/ou un faisceau laser est produit au moyen d'un laser picoseconde (14) ou d'un laser femtoseconde.

11. Procédé selon l'une des revendications précédentes,
**caractérisé**
**en ce que** la lame (1) présente une extension, un diamètre et/ou une longueur de côté moyen(ne) compris(e) entre 1 mm et 5 mm, de préférence de 3 mm, une épaisseur moyenne d₁ comprise entre 50 µm et 200 µm, de préférence de 100 µm, et/ou une extension, un diamètre et/ou une longueur de côté moyen(ne) qui s'élève au moins à 15 fois, et de préférence au moins à 25 fois son épaisseur moyenne d₁,
et/ou
**en ce que** la lame (1) est fabriquée par meulage mécanique, par sciage, par érosion laser ou par érosion par étincelage au plasma.

12. Procédé selon l'une des revendications précédentes,
**caractérisé**
**en ce que** le faisceau laser (3) est produit avec une unité d'irradiation (15), et
**en ce qu'**un support d'échantillon (11) est utilisé pour positionner la lame (1) dans le faisceau laser (3).
